# EUROPEAN PATENT APPLICATION

(11) **EP 4 752 689 A1**
(43) Date of publication of application: **03.06.2026**
(21) Application number: 25204575.2
(22) Date of filing: 25.09.2025
(51) Int. Cl.: G06F 3/041, G06F 3/044

(54) **DISPLAY DEVICE**

(30) Priority: 02.12.2024 KR 20240176558
(71) Applicant: LG Display Co., Ltd., Seoul, 07336 (KR)
(72) Inventor: KIM, Seunghyun, 10845 Paju-si, Gyeonggi-do (KR)
(74) Representative: Viering, Jentschura & Partner mbB Patent- und Rechtsanwälte

(57) **Abstract**

The embodiments of the present disclosure may provide a display device (100) comprising: a substrate (SUB) including a display area (DA) capable of displaying an image, the display area (DA) including a first display area (DA1) having a plurality of transmissive areas (TA) and a second display area (DA2) positioned outside the first display area (DA1); a touch sensor metal (TSM) disposed in the first display area (DA1) and positioned outside the plurality of transmissive areas (TA); a first signal line (SL1) disposed in the first display area (DA1) and at least partially overlapping with a portion of the touch sensor metal (TSM); and a second signal line (SL2) disposed in the first display area (DA1) and at least partially overlapping with another portion of the touch sensor metal (TSM).

Accordingly, the embodiments of the present disclosure may provide a display device (100) having an optical transmission structure that allows an optoelectronic device disposed below the display panel (110) to properly receive light while maintaining touch performance in an optical area (OA).

## Description

### TECHNICAL FIELD

The present disclosure relates to a display device.

### BACKGROUND

As the information society advances, the demand for display devices for displaying images has been increasing in various forms. In recent years, various types of display devices such as liquid crystal displays (LCDs), plasma display panels (PDPs), and organic light-emitting displays (OLEDs) have been widely used.

Among such display devices, there are touch display devices that provide a touch-based input method, allowing users to conveniently and intuitively input information or commands. To enable a touch-based input method, a touch display device must be capable of detecting whether a user has touched the screen and accurately identifying the touch coordinates.

In addition to image display functions, display devices may provide camera functionality and various sensing functions. To achieve this, a display device may be equipped with optoelectronic devices (also referred to as light-receiving devices or sensors), such as cameras and sensing sensors.

### SUMMARY

Embodiments of the present disclosure may provide a display device including a transmissive area that achieves a touch performance equal to or substantially equal to that of a non-transmissive area.

Embodiments of the present disclosure may provide a display device having an optical transmission structure that allows an optoelectronic device disposed below the display panel to receive light normally while maintaining touch performance in an optical area.

Embodiments of the present disclosure may provide a display device with improved visibility by preventing luminance differences between areas with and without a touch sensor metal.

Embodiments of the present disclosure may provide a display device with improved touch performance by reducing the resistance of the touch sensor metal and increasing capacitance.

Embodiments of the present disclosure may provide a display device that enhances transmittance in an optical area requiring optical transmission while arranging signal lines necessary for display driving in the optical area.

Embodiments of the present disclosure may provide a display device that enhances transmittance in an optical area requiring optical transmission, even while arranging both signal lines necessary for display driving and touch sensor metals necessary for touch sensing in the optical area.

The objects addressed by embodiments of the present disclosure are not limited to those explicitly mentioned, and additional objects not specified herein will be clearly understood by those skilled in the art from the descriptions below. Embodiments of the present disclosure may display devices according to the independent claims. Further embodiments are described in the dependent claims.

Embodiments of the present disclosure may provide a display device comprising: a substrate including a display area capable of displaying an image, the display area including a first display area having a plurality of transmissive areas and a second display area positioned outside the first display area; a touch sensor metal disposed in the first display area and positioned outside the plurality of transmissive areas; a first signal line disposed in the first display area and at least partially overlapping with a portion of the touch sensor metal; and a second signal line disposed in the first display area and at least partially overlapping with another portion of the touch sensor metal.

Embodiments of the present disclosure may provide a display device comprising: a substrate including a display area capable of displaying an image, the display area including a first display area having a plurality of transmissive areas and a second display area positioned outside the first display area; a first touch sensor metal disposed in the first display area and having a plurality of openings; and at least one signal line disposed in the first display area, wherein the first touch sensor metal comprises: a first portion surrounding a first emission area; a second portion surrounding a second emission area spaced apart from the first emission area in a first direction; and a third portion connecting the first portion and the second portion and arranged in a line shape, wherein the at least one signal line includes a wiring part disposed parallel to the third portion and at least partially overlapping with the third portion.

Embodiments of the present disclosure may provide a display device comprising: a substrate including a display area in which an image is displayed and a non-display area in which an image is not displayed, the display area including a first display area having a plurality of transmissive areas and a second display area positioned outside the first display area, the non-display area including a first non-display area and a second non-display area; a touch electrode disposed in an optical area within the first display area and the second display area, and having a plurality of openings; at least one signal line disposed in the first display area; and at least one power supply line.

According to embodiments of the present disclosure, a display device may be provided that includes a transmissive area achieving a touch performance equal to or substantially equal to that of a non-transmissive area.

According to embodiments of the present disclosure, a display device may be provided that includes an optical transmission structure allowing an optoelectronic device disposed below the display panel to receive light normally while maintaining touch performance in an optical area.

According to embodiments of the present disclosure, a display device may be provided with improved visibility by preventing luminance differences between areas with and without a touch sensor metal.

According to embodiments of the present disclosure, a display device may be provided with improved touch performance by reducing the resistance of the touch sensor metal and increasing capacitance.

According to embodiments of the present disclosure, a display device may be provided that enables normal touch functionality in an optical area included in the display area of a display panel and overlapped by an optoelectronic device.

According to embodiments of the present disclosure, a display device may be provided that enhances transmittance in an optical area requiring optical transmission while arranging signal lines necessary for display driving, thereby allowing an optoelectronic device positioned in the optical area to normally receive light transmitted through the optical area.

According to embodiments of the present disclosure, a display device may be provided that enhances transmittance in an optical area requiring optical transmission by overlapping the vertical positions of signal lines necessary for display driving and touch sensor metal necessary for touch sensing, even when both the signal lines and the touch sensor metal are arranged in the optical area.

According to embodiments of the present disclosure, a display device may be provided that allows for low-power operation by reducing the resistance of the touch sensor metal and increasing capacitance, thereby improving charge mobility.

The effects of embodiments of the present disclosure are not limited to those mentioned above, and additional effects not specified herein will be clearly understood by those skilled in the art from the descriptions below.

### BRIEF DESCRIPTION OF THE DRAWINGS

The present disclosure will be more fully understood from the following detailed description and the accompanying drawings. The detailed description and drawings are provided solely for illustrative purposes and are not intended to limit the scope of the present disclosure.
FIG. 1 illustrates a display device according to embodiments of the present disclosure.
FIG. 2 is a system configuration diagram of a display device according to embodiments of the present disclosure.
FIG. 3 illustrates a display panel according to embodiments of the present disclosure.
FIG. 4 is an equivalent circuit diagram of a pixel that may be included in a display device according to embodiments of the present disclosure.
FIG. 5 illustrates a first optical area, a second optical area, and a second display area in a display panel according to embodiments of the present disclosure.
FIG. 6 is a cross-sectional view of a first display area in a display panel according to embodiments of the present disclosure.
FIG. 7 is a cross-sectional view of a second display area in a display panel according to embodiments of the present disclosure.
FIG. 8 is a diagram illustrating a correspondence relationship between mesh-type touch electrodes and sub-pixels arranged in a display panel of a display device according to embodiments of the present disclosure.
FIG. 9 is a plan view of touch sensor metal disposed in an optical area and a second display area of a display device according to embodiments of the present disclosure.
FIG. 10 is an enlarged plan view of touch sensor metal disposed in an optical area and a second display area of a display device according to embodiments of the present disclosure.
FIG. 11 and FIG. 12 are cross-sectional views of transmissive areas and low-transmittance areas in an optical area of a display device according to embodiments of the present disclosure.
FIG. 13 illustrates changes in the resistance of touch electrodes before and after placing touch sensor metal in an optical area according to embodiments of the present disclosure.
FIG. 14 illustrates changes in capacitance of touch electrodes before and after placing touch sensor metal in an optical area according to embodiments of the present disclosure.
FIG. 15 illustrates a display device according to embodiments of the present disclosure.
FIG. 16 is an enlarged plan view of a second non-display area in a display device according to embodiments of the present disclosure.
FIG. 17 is an enlarged plan view of a second non-display area and a first optical area in a display device according to embodiments of the present disclosure.

### DETAILED DESCRIPTION

In the following description of examples or embodiments of the present invention, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present invention, detailed descriptions of well-known functions and components incorporated herein will be omitted when it is determined that the description may make the subject matter in some embodiments of the present invention rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present invention. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe nonconsecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, embodiments will be described in detail with reference to the accompanying drawings.

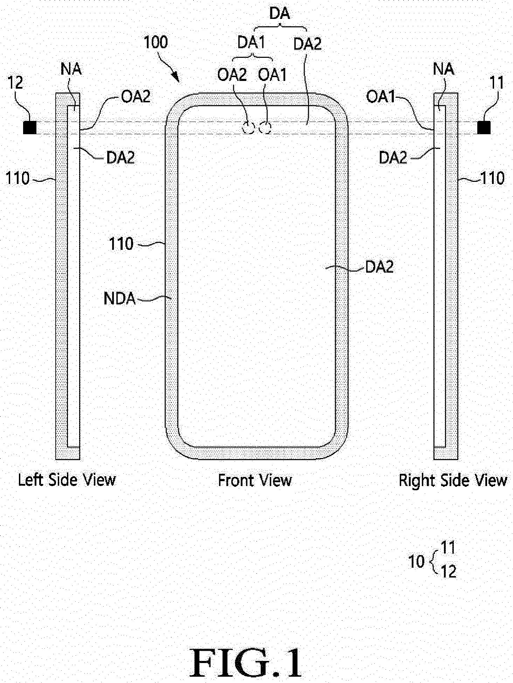

FIG. 1 illustrates a display device 100 according to embodiments of the present disclosure.

Referring to FIG. 1, the display device 100 according to embodiments of the present disclosure may include a display panel 110 that displays images and an electronic device 10.

In the display device 100 according to embodiments of the present disclosure, the electronic device 10 may receive light transmitted through the display panel 110 and perform a predetermined operation using the received light.

The electronic device 10 may include a first electronic device 11 and a second electronic device 12.

The display panel 110 may include a display area DA, where images (pictures) may be displayed, and a non-display area NDA, where images are not displayed.

In the display area DA, a plurality of sub-pixels and various signal lines (SL1, SL2) for driving the plurality of sub-pixels may be arranged.

The non-display area NDA may be an outer area of the display area DA. Various signal lines (SL1, SL2) may be arranged in the non-display area NDA, and various driving circuits may be connected thereto. The non-display area NDA may be bent so as not to be visible from the front or may be covered by a case (not shown). The non-display area NDA may also be referred to as a bezel or a bezel area.

An optical area OA may be included in a first display area DA1 where light can be transmitted, and a normal area NA may correspond to or be included in a second display area DA2 where light is not transmitted.

Hereinafter, the normal area NA may be referred to as the second display area DA2.

The display area DA may include the normal area NA and at least one optical area OA1 and OA2. At least a portion of the first optical area OA1 may overlap the first electronic device 11, and at least a portion of the second optical area OA2 may overlap the second electronic device 12.

The one or more electronic devices 11 and 12 are electronic components that are separately provided and installed from the display panel 110 and are located below (on the opposite side of the viewing surface of) the display panel 110.

The one or more electronic devices 11 and 12 require light reception but are positioned behind (below, on the opposite side of the viewing surface of) the display panel 110 and thus receive light transmitted through the display panel 110. The one or more electronic devices 11 and 12 are not exposed on the front (viewing surface) of the display panel 110. Accordingly, when a user views the front of the display panel 110, the one or more electronic devices 11 and 12 are not visible to the user.

Light may enter through the front (viewing surface) of the display panel 110, pass through the display panel 110, and be delivered to the one or more electronic devices 11 and 12 positioned below (on the opposite side of the viewing surface of) the display panel 110. For example, the light transmitted through the display panel 110 may include visible light or infrared light.

The one or more optical areas OA1 and OA2 must have both an image display structure and a light transmission structure. That is, since the one or more optical areas OA1 and OA2 are part of the display area DA, emission areas of sub-pixels for image display must be arranged therein. Furthermore, the one or more optical areas OA1 and OA2 must have a light transmission structure for transmitting light to the one or more electronic devices 11 and 12.

For example, the first electronic device 11 may be a sensing sensor, and the second electronic device 12 may be a camera. For example, the sensing sensor may be an infrared sensor that detects infrared light. Conversely, the first electronic device 11 may be a camera, and the second electronic device 12 may be a sensing sensor such as a proximity sensor or an ambient light sensor.

Hereinafter, for convenience of explanation, an example will be given in which the first electronic device 11 is an infrared-based sensing sensor, and the second electronic device 12 is a camera. Here, the camera may be a camera lens or an image sensor.

The normal area NA and the one or more optical areas OA1 and OA2 are areas where image display is possible. However, the normal area NA is an area where a light transmission structure does not need to be formed, whereas the one or more optical areas OA1 and OA2 are areas where a light transmission structure must be formed.

That is, in the display device 100 according to embodiments of the present disclosure, even though the one or more electronic devices 11 and 12 are positioned hidden behind the display panel 110 and overlap with the display area DA, normal image display must be possible in the one or more optical areas OA1 and OA2 overlapping the one or more electronic devices 11 and 12 within the display area DA.

Accordingly, the one or more optical areas OA1 and OA2 must have a transmittance above a certain level, whereas the normal area NA may not have light transmittance or may have a low transmittance below a certain level.

For example, the one or more optical areas OA1 and OA2 and the normal area NA may differ in terms of resolution, sub-pixel arrangement structure, the number of sub-pixels per unit area, electrode structure, line structure, electrode arrangement structure, or line arrangement structure.

For example, the number of sub-pixels per unit area in the one or more optical areas OA1 and OA2 may be smaller than that in the normal area NA. That is, the resolution of the one or more optical areas OA1 and OA2 may be lower than the resolution of the normal area NA. Here, the number of sub-pixels per unit area may have the same meaning as resolution, pixel density, or pixel integration density. For example, the unit of the number of sub-pixels per unit area may be expressed as PPI (Pixels Per Inch), which represents the number of pixels within one inch.

For example, the number of sub-pixels per unit area in the first optical area OA1 may be smaller than that in the normal area NA. The number of sub-pixels per unit area in the second optical area OA2 may be equal to or greater than that in the first optical area OA1 and smaller than that in the normal area NA.

The first optical area OA1 may have various shapes, such as circular, elliptical, rectangular, hexagonal, or octagonal. The second optical area OA2 may also have various shapes, such as circular, elliptical, rectangular, hexagonal, or octagonal. The first optical area OA1 and the second optical area OA2 may have the same shape or different shapes. The sizes of the first optical area OA1 and the second optical area OA2 may differ. For example, the size of the first optical area OA1, where a camera is disposed, may be larger than the size of the second optical area OA2, where a sensor is disposed. In another example, the size of the first optical area OA1 may be smaller than the size of the second optical area OA2.

In the display device 100 according to embodiments of the present disclosure, if the first electronic device 11, which is hidden under the display panel 110 and not exposed externally, is an infrared sensing sensor, the display device 100 may be a display to which under-display infrared (UDIR) technology is applied.

In the display device 100 according to embodiments of the present disclosure, if the second electronic device 12, which is hidden under the display panel 110 and not exposed externally, is a camera, the display device 100 may be a display to which under-display camera (UDC) technology is applied.

Accordingly, in the display device 100 according to embodiments of the present disclosure, a notch or hole for exposing a sensor or a camera does not need to be formed in the display panel 110. As a result, the area of the display area DA is not reduced. Consequently, the size of the bezel area may be reduced, and design constraints may be eliminated, increasing the degree of freedom in design.

The display device 100 according to embodiments of the present disclosure may provide both an image display function for displaying images and a touch sensing function for detecting the presence or absence of touch and/or touch coordinates in response to touch manipulation by a touch object such as a user's finger or a pen.

These functions are also applicable to the optical area OA. The display device 100 according to embodiments of the present disclosure may provide a touch sensing function for detecting the presence or absence of touch and/or touch coordinates while normally displaying images even in the optical area OA.

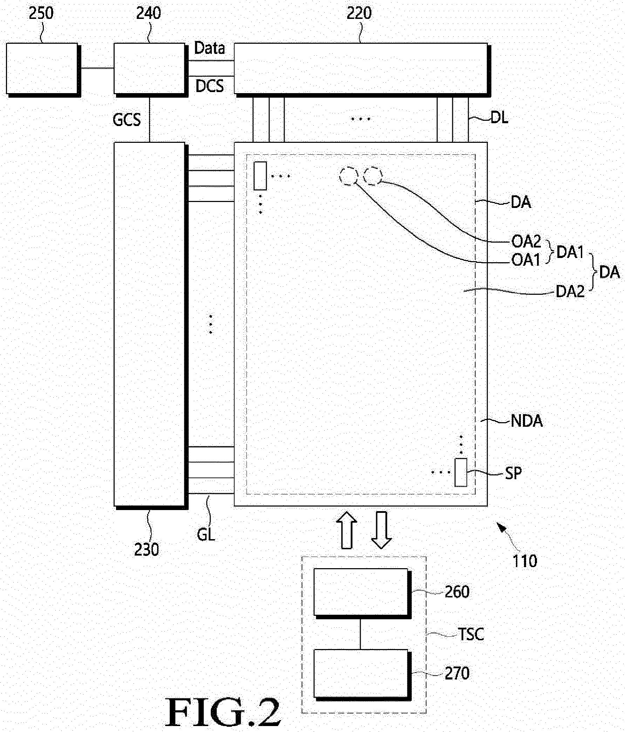

FIG. 2 is a system configuration diagram of the display device 100 according to embodiments of the present disclosure.

Referring to FIG. 2, the display device 100 may include a display panel 110 and a display driving circuit as components for image display.

The display driving circuit may be a circuit for driving the display panel 110 and may include a data driving circuit 220, a gate driving circuit 230, and a display controller 240.

The display panel 110 may include a display area DA in which an image is displayed and a non-display area NDA in which an image is not displayed. The non-display area NDA may be an outer region of the display area DA and may also be referred to as a bezel area. The entire or a portion of the non-display area NDA may be a region visible from the front of the display device 100, or it may be bent so as not to be visible from the front of the display device 100.

The display panel 110 may include a substrate SUB and a plurality of sub-pixels SP disposed on the substrate SUB. Additionally, the display panel 110 may further include various types of signal lines (SL1, SL2) to drive the plurality of sub-pixels SP.

The display device 100 according to embodiments of the present disclosure may be a liquid crystal display (LCD) or a self-emissive display device in which the display panel 110 itself emits light. When the display device 100 is a self-emissive display device, each of the plurality of sub-pixels SP may include a light-emitting device. For example, the display device 100 according to embodiments of the present disclosure may be an organic light-emitting display device in which the light-emitting device is implemented as an organic light-emitting diode (OLED). In another example, the display device 100 may be an inorganic light-emitting display device in which the light-emitting device is implemented as an inorganic-based light-emitting diode. In yet another example, the display device 100 may be a quantum dot display device in which the light-emitting device is implemented as a quantum dot, which is a semiconductor crystal that emits light by itself.

The structure of each of the plurality of sub-pixels SP may vary depending on the type of the display device 100. For example, when the display device 100 is a self-emissive display device in which each sub-pixel SP emits light by itself, each sub-pixel SP may include a light-emitting device which self-emits light, one or more transistors, and one or more capacitors.

For example, various types of signal lines (SL1, SL2) may include a plurality of data lines DL that transmit data signals (also referred to as data voltages or image signals) and a plurality of gate lines GL that transmit gate signals (also referred to as scan signals).

The plurality of data lines DL and the plurality of gate lines GL may intersect each other. Each of the plurality of data lines DL may be arranged extending in a first direction, and each of the plurality of gate lines GL may be arranged extending in a second direction. Here, the first direction may be a column direction, and the second direction may be a row direction. Alternatively, the first direction may be a row direction, and the second direction may be a column direction.

The data driving circuit 220 may be a circuit for driving the plurality of data lines DL and may output data signals to the plurality of data lines DL. The gate driving circuit 230 may be a circuit for driving the plurality of gate lines GL and may output gate signals to the plurality of gate lines GL.

The display controller 240 may be a device for controlling the data driving circuit 220 and the gate driving circuit 230 and may control the driving timing of the plurality of data lines DL and the plurality of gate lines GL.

The display controller 240 may supply a data driving control signal DCS to the data driving circuit 220 to control the data driving circuit 220 and may supply a gate driving control signal GCS to the gate driving circuit 230 to control the gate driving circuit 230.

The display controller 240 may receive input image data from a host system 250 and supply digital image data Data to the data driving circuit 220 based on the input image data.

The data driving circuit 220 may receive digital image data Data from the display controller 240, convert the received digital image data Data into analog data signals, and output the analog data signals to the plurality of data lines DL.

The gate driving circuit 230 may generate gate signals by receiving the first gate voltage corresponding to a turn-on level voltage and the second gate voltage corresponding to a turn-off level voltage, along with various gate driving control signals GCS, and may supply the generated gate signals to the plurality of gate lines GL.

For example, the data driving circuit 220 may be connected to the display panel 110 through tape automated bonding (TAB) technology or may be connected to a bonding pad of the display panel 110 using chip-on-glass (COG) or chip-on-panel (COP) technology. Additionally, the data driving circuit 220 may be implemented as a chip-on-film (COF) technology and connected to the display panel 110.

The gate driving circuit 230 may be connected to the display panel 110 through tape automated bonding (TAB) technology or may be connected to a bonding pad of the display panel 110 using chip-on-glass (COG) or chip-on-panel (COP) technology. Additionally, the gate driving circuit 230 may be connected to the display panel 110 using chip-on-film (COF) technology. The gate driving circuit 230 may be disposed on the substrate or connected to the substrate. That is, if the gate driving circuit 230 is a GIP type, it may be disposed in the non-display area NDA of the substrate. If the gate driving circuit 230 is a COG or COF type, it may be connected to the substrate.

Meanwhile, at least one of the data driving circuit 220 and the gate driving circuit 230 may be disposed in the display area DA of the display panel 110. For example, at least one of the data driving circuit 220 and the gate driving circuit 230 may be disposed without overlapping the sub-pixels SP, or it may be partially or entirely overlapped with the sub-pixels SP.

The data driving circuit 220 may be connected to one side (e.g., the upper or lower side) of the display panel 110. Depending on the driving method or panel design method, the data driving circuit 220 may be connected to both sides (e.g., the upper and lower sides) of the display panel 110 or to two or more of the four sides of the display panel 110.

The gate driving circuit 230 may be connected to one side (e.g., the left or right side) of the display panel 110. Depending on the driving method or panel design method, the gate driving circuit 230 may be connected to both sides (e.g., the left and right sides) of the display panel 110 or to two or more of the four sides of the display panel 110.

The display controller 240 may be implemented as a separate component from the data driving circuit 220 or may be integrated with the data driving circuit 220 as an integrated circuit (IC).

The display device 100 according to embodiments of the present disclosure may include a touch sensor TS and a touch sensing circuit TSC to provide not only an image display function but also a touch sensing function. The touch sensing circuit TSC may detect whether a touch has occurred by a touch object such as a finger or a pen, or determine the touch position.

The touch sensing circuit TSC may include a touch driving circuit 260 that drives and senses the touch sensor to generate and output touch sensing data, and a touch controller 270 that detects a touch event or determines a touch position based on the touch sensing data.

The touch sensor may include a plurality of touch electrodes. The touch sensor may further include a plurality of touch lines electrically connecting the plurality of touch electrodes to the touch driving circuit 260.

The touch sensor may be present as a touch panel external to the display panel 110 or may be integrated inside the display panel 110.

When the touch sensor is integrated inside the display panel 110, it may be formed on the substrate SUB along with signal lines (SL1, SL2) and electrodes related to display driving during the manufacturing process of the display panel 110.

The touch driving circuit 260 may supply a touch driving signal to at least one of the plurality of touch electrodes and sense at least one of the plurality of touch electrodes to generate touch sensing data.

In the display panel 110, the display area DA may include a first display area DA1 and a second display area DA2.

The first display area DA1 may include one or more optical areas OA1, OA2, and the second display area DA2 may include a normal area NA. The first display area DA1 and the second display area DA2 are both regions where image display is possible. However, the second display area DA2 is a region where an optical transmission structure and transmissive areas do not need to be formed, whereas the first display area DA1 is a region where an optical transmission structure and transmissive areas should be formed.

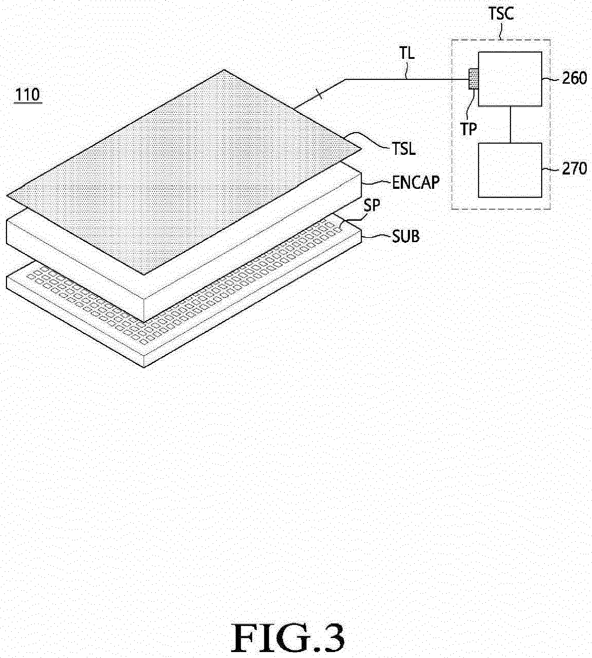

FIG. 3 illustrates the display panel 110 according to embodiments of the present disclosure.

Referring to FIG. 3, a plurality of sub-pixels SP may be arranged in the display area DA of the display panel 110. The plurality of sub-pixels SP may be disposed in the normal area NA and the optical area OA included in the display area DA.

The display panel 110 may further include a plurality of touch pads TP electrically connected to the touch driving circuit 260 and a plurality of touch routing lines TL electrically connecting a plurality of sensor electrodes included in a touch sensor layer TSL to the plurality of touch pads TP connected to the touch driving circuit 260.

The touch sensing circuit TSC may include a touch driving circuit 260 that supplies a driving signal and receives a sensing signal, and a touch controller 270 that calculates the presence or absence of a touch and/or a touch position (touch coordinates).

Meanwhile, the touch sensing circuit TSC of the display device 100 according to embodiments of the present disclosure may sense touch based on capacitance formed in a touch electrode TE.

In this case, the touch sensing circuit TSC may obtain touch presence and/or touch coordinates based on changes in self-capacitance, or may obtain touch presence and/or touch coordinates based on changes in mutual capacitance of the touch sensor. Hereinafter, for convenience of explanation, an example will be described in which the touch display device according to embodiments of the present disclosure senses touch based on mutual capacitance.

In a mutual-capacitance-based touch sensing method, the touch sensing circuit applies a driving signal to one or more driving touch electrode lines, receives a sensing signal from one or more sensing touch electrode lines, and detects touch presence and/or touch coordinates based on the change in capacitance (mutual capacitance) between the driving touch electrode lines and the sensing touch electrode lines depending on the presence of a pointer such as a finger or pen.

The touch sensor layer TSL may be embedded in the display panel 110.

For example, the touch sensor layer TSL may be disposed on an encapsulation layer ENCAP in the display panel 110. That is, in the touch display device, the touch sensor may be disposed on the encapsulation layer ENCAP. This is referred to as a touch sensor on encapsulation layer (TOE) structure.

The encapsulation layer ENCAP may be formed as a single layer or as multiple layers. For example, when the encapsulation layer ENCAP is composed of multiple layers, it may include one or more inorganic encapsulation layers and one or more organic encapsulation layers. Specifically, the encapsulation layer ENCAP may include a first inorganic encapsulation layer, an organic encapsulation layer, and a second inorganic encapsulation layer. Here, the organic encapsulation layer may be positioned between the first inorganic encapsulation layer and the second inorganic encapsulation layer.

The first inorganic encapsulation layer may be formed on a common electrode (e.g., a cathode electrode) to be closest to a light-emitting device ED. This first inorganic encapsulation layer may be formed of an inorganic insulating material that can be deposited at a low temperature, such as silicon nitride (SiNx), silicon oxide (SiOx), silicon oxynitride (SiON), or aluminum oxide (Al₂O₃). Accordingly, since the first inorganic encapsulation layer is deposited in a low-temperature environment, it is possible to prevent damage to the light-emitting layer (organic light-emitting layer), which is vulnerable to high-temperature environments during the deposition process of the first inorganic encapsulation layer.

The organic encapsulation layer may be formed to have a smaller area than the first inorganic encapsulation layer and may be formed to expose both ends of the first inorganic encapsulation layer. This organic encapsulation layer acts as a buffer that alleviates stress between the layers due to the bending of the touch display device and enhances the planarization performance. The organic encapsulation layer may be formed of an organic insulating material such as acrylic resin, epoxy resin, polyimide, polyethylene, or silicon oxycarbon (SiOC).

The second inorganic encapsulation layer may be formed on the organic encapsulation layer to cover the upper and side surfaces of both the organic encapsulation layer and the first inorganic encapsulation layer. Accordingly, the second inorganic encapsulation layer may minimize or block penetration of external moisture or oxygen into the first inorganic encapsulation layer and the organic encapsulation layer. The second inorganic encapsulation layer may include an inorganic insulating material such as silicon nitride (SiNx), silicon oxide (SiOx), silicon oxynitride (SiON), or aluminum oxide (Al₂O₃).

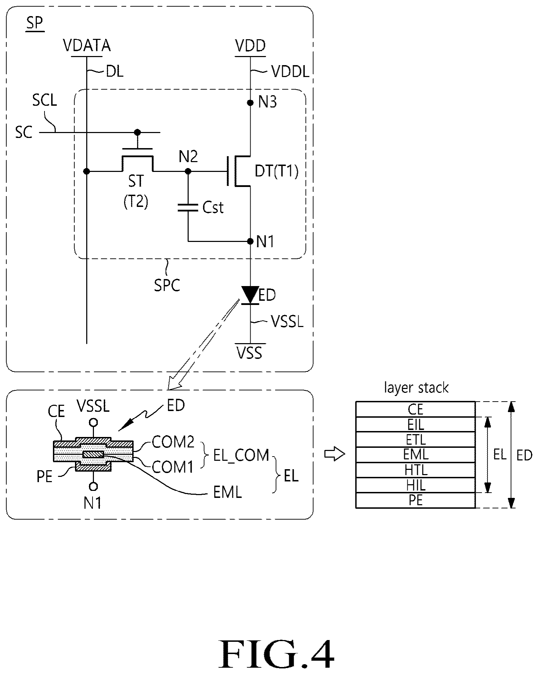

FIG. 4 is an equivalent circuit diagram of a pixel that may be included in a display device according to embodiments of the present disclosure.

Referring to FIG. 4, a sub-pixel circuit SPC included in each sub-pixel SP may include a driving transistor DT for driving a light-emitting device ED, a scan transistor ST for delivering a data voltage VDATA to the driving transistor DT, and a storage capacitor Cst for maintaining a constant voltage for one frame.

The driving transistor DT may include a first node N1, a second node N2, and a third node N3.

The first node N1 may be a node connected to the light-emitting device ED. The second node N2 may be a node connected to the scan transistor ST. The third node N3 may be a node connected to a driving voltage line VDDL.

The first node N1 may be electrically connected to a pixel electrode PE of the light-emitting device ED. The data voltage VDATA may be applied to the second node N2 via the scan transistor ST. The driving voltage VDD may be applied to the third node N3.

The first node N1 may be a source node or a drain node, the second node N2 may be a gate node, and the third node N3 may be a drain node or a source node. Hereinafter, for convenience of explanation, an example is given in which the first node N1 is a source node, the second node N2 is a gate node, and the third node N3 is a drain node in the driving transistor DT.

The light-emitting device ED may include a pixel electrode PE, an intermediate layer EL, and a common electrode CE.

The pixel electrode PE may be an electrode disposed in each sub-pixel SP. For example, the pixel electrode PE may be electrically connected to the first node N1 of the driving transistor DT of each sub-pixel SP, either directly or indirectly through another transistor.

The common electrode CE may be an electrode commonly disposed across the plurality of sub-pixels SP. For example, the common electrode CE may receive a reference voltage VSS, which is a type of common driving voltage, through a reference voltage line VSSL.

For example, the pixel electrode PE may be an anode electrode, and the common electrode CE may be a cathode electrode. Conversely, the pixel electrode PE may be a cathode electrode, and the common electrode CE may be an anode electrode. Hereinafter, for convenience of explanation, it is assumed that the pixel electrode PE is an anode electrode and the common electrode CE is a cathode electrode.

The intermediate layer EL may include a light-emitting layer EML and a common intermediate layer EL_COM.

The light-emitting layer EML may be disposed in the emission area of each sub-pixel SP. For example, the light-emitting layer EML may be disposed only in each of the plurality of sub-pixels SP. Alternatively, the light-emitting layer EML may be commonly disposed in multiple sub-pixels SP. In another example, the light-emitting layer EML may be disposed only in the emission area. In yet another example, the light-emitting layer EML may be disposed in both the emission area and the non-emission area.

The common intermediate layer EL_COM may be commonly disposed across multiple sub-pixels SP. The common intermediate layer EL_COM may be commonly disposed across multiple emission areas EA and non-emission areas.

The common intermediate layer EL_COM may include a first common intermediate layer COM1 and a second common intermediate layer COM2. The first common intermediate layer COM1 may be disposed between the pixel electrode PE and the light-emitting layer EML and may include at least one layer, such as an organic layer. The second common intermediate layer COM2 may be disposed between the light-emitting layer EML and the common electrode CE and may include at least one layer, such as an organic layer. For example, the first common intermediate layer COM1 may include a hole injection layer HIL and a hole transport layer HTL. The second common intermediate layer COM2 may include an electron transport layer ETL and an electron injection layer EIL.

The hole injection layer HIL injects holes from the pixel electrode PE to the hole transport layer HTL, the hole transport layer HTL transports holes to the light-emitting layer EML, the electron injection layer EIL injects electrons from the common electrode CE to the electron transport layer ETL, and the electron transport layer ETL transports electrons to the light-emitting layer EML. Each light-emitting device ED may be configured in an overlapping portion of the pixel electrode PE, the light-emitting layer EML in the intermediate layer EL, and the common electrode CE. A predetermined emission area EA may be defined by each light-emitting device ED. For example, the emission area EA may be defined as a region where the pixel electrode PE, the light-emitting layer EML in the intermediate layer EL, and the common electrode CE overlap.

For example, the light-emitting device ED may be an organic light-emitting diode (OLED), an inorganic light-emitting diode, or a quantum dot light-emitting device. When the light-emitting device ED is an inorganic light-emitting diode (OLED), the intermediate layer EL in the light-emitting device ED may include an organic layer containing organic material.

The scan transistor ST may be turned on or off by a scan signal SC, which is a type of gate signal applied through a scan signal line SCL that is a type of gate line GL, and may be electrically connected between the second node N2 of the driving transistor DT and the data line DL.

The storage capacitor Cst may be electrically connected between the first node N1 and the second node N2 of the driving transistor DT.

The sub-pixel circuit SPC may have a 2T1C structure including two transistors DT(T1) and ST(T2) and one capacitor Cst, as shown in FIG. 4, and may additionally include one or more transistors or one or more capacitors depending on the case.

The storage capacitor Cst may be an external capacitor intentionally designed outside the driving transistor DT, rather than an internal capacitor, such as a parasitic capacitor, that may exist between the first and second nodes N1 and N2 of the driving transistor DT. The driving transistor DT and the scan transistor ST may each be an n-type transistor or a p-type transistor.

Each sub-pixel SP includes circuit elements (particularly, a light-emitting device ED implemented as an organic light-emitting diode OLED including organic materials), which are vulnerable to external moisture or oxygen. Accordingly, an encapsulation layer ENCAP may be disposed in the display panel 110 to prevent external moisture or oxygen from penetrating into the circuit elements (particularly, the light-emitting device ED). The encapsulation layer ENCAP may be disposed to cover the light-emitting devices ED.

Each sub-pixel SP may include a light-emitting device ED, a first transistor T1 for driving the light-emitting device ED, a second transistor T2 for delivering a data voltage VDATA to a second node N2 of the first transistor T1, and a storage capacitor Cst for maintaining a constant voltage for one frame.

The first transistor T1 may include a first node N1 electrically connected to the light-emitting device ED, a second node N2 to which a data voltage may be applied, and a third node N3 to which a driving voltage VDD is applied from a driving voltage line VDDL. The first node N1 may be a source node or a drain node, the second node N2 may be a gate node, and the third node N3 may be a drain node or a source node. The first transistor T1 is also referred to as a driving transistor for driving the light-emitting device ED.

The light-emitting device ED may include a pixel electrode (e.g., an anode electrode), a light-emitting layer, and a common electrode (e.g., a cathode electrode). The pixel electrode may receive a driving voltage VDD corresponding to a different pixel voltage for each sub-pixel SP and may be electrically connected to the first node N1 of the first transistor T1, and the common electrode may receive a reference voltage VSS, which is a common voltage applied to all sub-pixels SP.

The light-emitting device ED may be an organic light-emitting device ED using organic materials or an inorganic light-emitting device ED using inorganic materials. In an organic light-emitting device ED, the light-emitting layer may include an organic light-emitting layer containing organic materials. In this case, the light-emitting device ED is referred to as an organic light-emitting diode (OLED).

The second transistor T2 may be turned on or off by a scan signal SC applied through a gate line GL (i.e., a scan signal line SCL) and may be electrically connected between the second node N2 of the first transistor T1 and the data line DL. The second transistor T2 is also referred to as a switching transistor.

When the second transistor T2 is turned on by the scan signal SC, the second transistor T2 delivers the data voltage VDATA supplied from the data line DL to the second node N2 of the first transistor T1.

The storage capacitor Cst may be electrically connected between the first node N1 and the second node N2 of the first transistor T1.

Each sub-pixel SP may have a 2T1C (Transistor-Capacitor) structure including two transistors T1 and T2 and one capacitor Cst, as illustrated in FIG. 3, and may additionally include one or more transistors or one or more capacitors in some cases.

The storage capacitor Cst is an external capacitor intentionally designed outside the first transistor T1 rather than a parasitic capacitor (e.g., Cgs, Cgd), which is an internal capacitor that may exist between the first node N1 and the second node N2 of the first transistor T1.

Each of the first transistor T1 and the second transistor T2 may be an n-type transistor or a p-type transistor.

Meanwhile, as described above, circuit elements such as the light-emitting device ED, at least two transistors T1 and T2, and at least one capacitor Cst are disposed in the display panel 110. Since these circuit elements (particularly, the light-emitting device ED) are vulnerable to external moisture or oxygen, an encapsulation layer ENCAP may be disposed in the display panel 110 to prevent external moisture or oxygen from penetrating into the circuit elements (particularly, the light-emitting device ED).

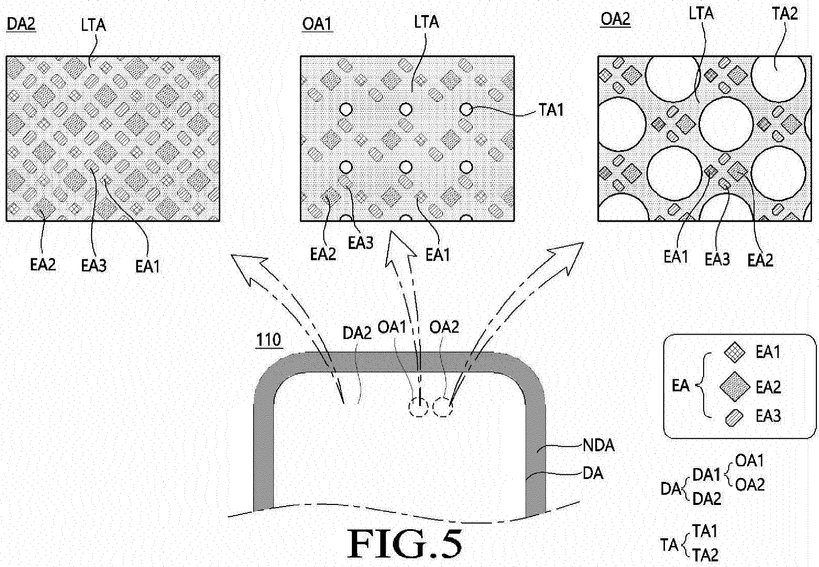

FIG. 5 illustrates a structure of a first display area DA1 and a second display area DA2 in the display panel 110 according to embodiments of the present disclosure.

Referring to FIG. 5, the display panel 110 according to embodiments of the present disclosure may include a display area DA in which an image is displayed and a non-display area NDA in which an image is not displayed. The display area DA may include a first display area DA1 and a second display area DA2. The first display area DA1 may include at least one of a first optical area OA1 and a second optical area OA2. For example, the first display area DA1 may include both the first optical area OA1 and the second optical area OA2.

Hereinafter, a case in which the first display area DA1 includes both the first optical area OA1 and the second optical area OA2 will be described as an example.

The first optical area OA1 and the second optical area OA2 may be areas in which optical transmission is possible, and the second display area DA2 may be an area in which optical transmission is minimal.

Here, optical transmission means that light entering through the front of the display panel 110 passes through the display panel 110 and exits from the back of the display panel 110.

The second display area DA2 may be an area excluding the first display area DA1.

At least a portion of the first optical area OA1 may be an area overlapping the first electronic device 11, and at least a portion of the second optical area OA2 may be an area overlapping the second electronic device 12.

Each of the first optical area OA1 and the second optical area OA2 may have an optical transmission structure. However, the first optical area OA1 and the second optical area OA2 may have different structural characteristics. For example, the optical transmittance of the first optical area OA1 may be lower than that of the second optical area OA2. Also, the resolution of the first optical area OA1 may be higher than that of the second optical area OA2. In another example, the number of sub-pixels per unit area in the first optical area OA1 may be greater than that in the second optical area OA2. In yet another example, the sub-pixel size of the first optical area OA1 may be larger than that of the second optical area OA2.

The first electronic device 11 may perform a predetermined operation using light of a first wavelength band among light transmitted through the first optical area OA1. The second electronic device 12 may perform a predetermined operation using light of a second wavelength band, different from the first wavelength band, among light transmitted through the second optical area OA2.

The first wavelength band may include one or more of the wavelength bands of visible light, infrared light, and ultraviolet light. The second wavelength band may include one or more of the wavelength bands of visible light, infrared light, and ultraviolet light but may be different from the first wavelength band.

For example, the first electronic device 11 may be a sensing sensor, and the second electronic device 12 may be a camera.

The first electronic device 11 may perform a sensing operation using light of an infrared wavelength band corresponding to the first wavelength band among light transmitted through the first optical area OA1. The second electronic device 12 may perform a camera operation using light of a visible light wavelength band corresponding to the second wavelength band among light transmitted through the second optical area OA2.

Referring to FIG. 5, each of the first optical area OA1 and the second optical area OA2 may be circular or octagonal. However, the first optical area OA1 and the second optical area OA2 are not limited thereto and may have various shapes such as an ellipse, a polygon, or an irregular shape.

The first optical area OA1 and the second optical area OA2 may have the same shape. Unlike this, the first optical area OA1 and the second optical area OA2 may have different shape.

Referring to FIG. 5, the display area DA may include a plurality of emission areas EA. Since the first display area DA1 and the second display area DA2 are included in the display area DA, the first display area DA1 and the second display area DA2 may include a plurality of emission areas EA.

The plurality of emission areas EA disposed in the display area DA may include a first color emission area EA1 emitting first-color light, a second color emission area EA2 emitting second-color light, and a third color emission area EA3 emitting third-color light.

At least one of the first color emission area EA1, the second color emission area EA2, and the third color emission area EA3 may have a different area from the others. The first color, the second color, and the third color may be different colors and may be various colors. For example, the first color, the second color, and the third color may include red, green, and blue.

Referring to FIG. 5, the first optical area OA1 and the second optical area OA2 in the first display area DA1 may include a plurality of emission areas EA and at least one transmissive area TA. The second display area DA2 may include a plurality of emission areas EA.

The first display area DA1 may include a plurality of transmissive areas TA and a low-transmittance area LTA. The low-transmittance area LTA may be an area of the first display area DA1 excluding the plurality of transmissive areas TA. The low-transmittance area LTA may include a plurality of emission areas EA.

The first optical area OA1 may include a low-transmittance area LTA in which a plurality of emission areas EA are included and a plurality of first transmissive areas TA1. The low-transmittance area LTA included in the first optical area OA1 may be an area in which light is transmitted at a lower transmittance than the first transmissive area TA1.

For example, each of the plurality of first transmissive areas TA1 may have various shapes such as a circle, an ellipse, a polygon, or an irregular shape. In one example, the plurality of first transmissive areas TA1 may have the same shape. In another example, some of the plurality of first transmissive areas TA1 may have a different shape from the others. The plurality of first transmissive areas TA1 may be separate areas or connected areas.

The second optical area OA2 may include a low-transmittance area LTA in which a plurality of emission areas EA are included and a plurality of second transmissive areas TA2. The low-transmittance area LTA included in the second optical area OA2 may be an area in which light is transmitted at a lower transmittance than the second transmissive area TA2.

For example, each of the plurality of second transmissive areas TA2 may have various shapes such as a circle, an ellipse, a polygon, or an irregular shape. In one example, the plurality of second transmissive areas TA2 may have the same shape. In another example, some of the plurality of second transmissive areas TA2 may have a different shape from the others. The plurality of second transmissive areas TA2 may be separate areas or connected areas.

In one example, the first transmissive area TA1 and the second transmissive area TA2 may have the same shape. In another example, the first transmissive area TA1 and the second transmissive area TA2 may have different shapes. The sizes of the first transmissive area TA1 and the second transmissive area TA2 may be different. For example, the area of the first transmissive area TA1 may be smaller than the area of the second transmissive area TA2.

Referring to FIG. 5, the second display area DA2 may be a low-transmittance area LTA. The second display area DA2 may include a low-transmittance area LTA in which a plurality of emission areas EA are included. In other words, the entire second display area DA2 may be a low-transmittance area LTA, and the second display area DA2 may not include a transmissive area TA.

Meanwhile, in order to enable touch across the entire display area DA, the plurality of touch electrodes TE should be disposed not only in the second display area DA2 but also in the first optical area OA1 and the second optical area OA2 within the first display area DA1.

Accordingly, embodiments of the present disclosure may provide a display device 100 in which the plurality of touch electrodes TE are arranged in a specific pattern and stacking structure in the first optical area OA1 and the second optical area OA2, thereby enabling touch sensing in the optical areas while allowing the first electronic device 11 and/or the second electronic device 12 disposed below the display panel to receive light normally.

That is, in embodiments of the present disclosure, the plurality of touch electrodes TE may be disposed in both the first optical area OA1 and the second optical area OA2 within the first display area DA1.

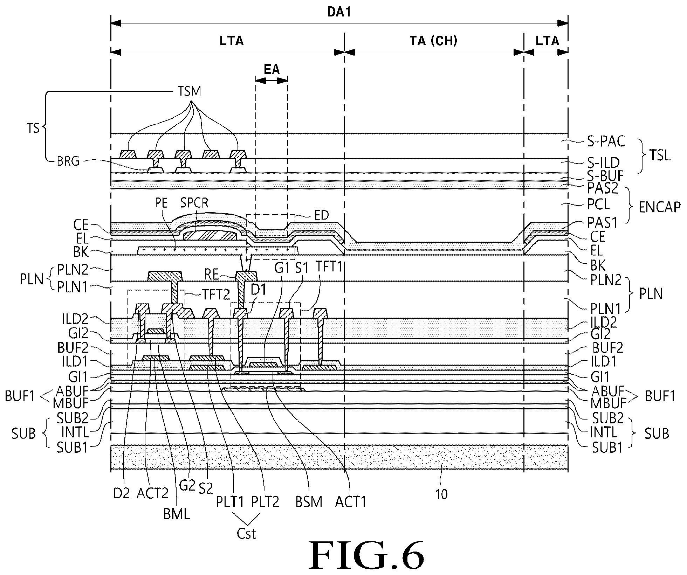

FIG. 6 is a cross-sectional view of the first display area DA1 in the display panel 110 according to embodiments of the present disclosure.

The first display area DA1 may include the first optical area OA1 and the second optical area OA2.

The first optical area OA1 may include a low-transmittance area LTA in which a plurality of emission areas EA are included, and a plurality of first transmissive areas TA1. The low-transmittance area LTA included in the first optical area OA1 may be an area where light transmits with lower transmittance than the plurality of first transmissive areas TA1.

The second optical area OA2 may include a low-transmittance area LTA in which a plurality of emission areas EA are included, and a plurality of second transmissive areas TA2. The low-transmittance area LTA included in the second optical area OA2 may be an area where light transmits with lower transmittance than the plurality of second transmissive areas TA2. The second transmissive areas TA2 included in the second optical area OA2 may be areas where light transmits with higher transmittance than the first transmissive areas TA1 included in the first optical area OA1. For example, the structure of the insulating layer included in the second transmissive area TA2 may be different from that of the insulating layer included in the first transmissive area TA1. For instance, the insulating layer structure in the second transmissive area TA2 may be configured to have a higher transmittance than that in the first transmissive area TA1 by removing some of the multiple insulating layers.

The display panel 110 may include a transistor formation portion, a light-emitting device formation portion, an encapsulation portion, and a touch sensor.

The transistor formation portion may include a substrate SUB, a first buffer layer BUF1 on the substrate SUB, and various transistors TFT1 and TFT2, a storage capacitor Cst, and various electrodes and signal lines formed on the first buffer layer BUF1.

The substrate SUB may include a first substrate SUB1, a second substrate SUB2, and an intermediate layer INTL between the first substrate SUB1 and the second substrate SUB2. Here, for example, the intermediate layer INTL may be an inorganic layer capable of blocking moisture penetration.

A bottom shield metal BSM may be disposed on the substrate SUB. The bottom shield metal BSM may be located below the first active layer ACT1 of the first transistor TFT1.

The first buffer layer BUF1 may be a single layer or a multi-layer. If the first buffer layer BUF1 is a multi-layer, it may include a multi-buffer layer MBUF and an active buffer layer ABUF.

Various transistors TFT1 and TFT2, a storage capacitor Cst, and various electrodes and signal lines may be formed on the first buffer layer BUF1.

For example, the transistors TFT1 and TFT2 formed on the first buffer layer BUF1 may be composed of the same material and positioned on the same layers. Alternatively, as shown in FIG. 6, the first transistor TFT1 and the second transistor TFT2 may be composed of different materials and positioned on different layers.

The first transistor TFT1 may include a first active layer ACT1, a first gate electrode G1, a first source electrode S1, and a first drain electrode D1. The second transistor TFT2 may include a second active layer ACT2, a second gate electrode G2, a second source electrode S2, and a second drain electrode D2.

The second active layer ACT2 of the second transistor TFT2 may be positioned higher than the first active layer ACT1 of the first transistor TFT1.

The first active layer ACT1 of the first transistor TFT1 and the second active layer ACT2 of the second transistor TFT2 may include different semiconductor materials. For example, the first active layer ACT1 of the first transistor TFT1 may include a different semiconductor material than the second active layer ACT2 of the second transistor TFT2. For instance, the first active layer ACT1 of the first transistor TFT1 may include a silicon-based semiconductor material. For example, the silicon-based semiconductor material may include low-temperature polycrystalline silicon (LTPS). The second active layer ACT2 of the second transistor TFT2 may include an oxide semiconductor material. For example, the oxide semiconductor material may include indium gallium zinc oxide (IGZO), indium gallium zinc tin oxide (IGZTO), zinc oxide (ZnO), cadmium oxide (CdO), indium oxide (InO), zinc tin oxide (ZTO), or zinc indium tin oxide (ZITO).

The first buffer layer BUF1 may be disposed below the first active layer ACT1 of the first transistor TFT1, and a second buffer layer BUF2 may be disposed below the second active layer ACT2 of the second transistor TFT2.

That is, the first active layer ACT1 of the first transistor TFT1 may be positioned on the first buffer layer BUF1, and the second active layer ACT2 of the second transistor TFT2 may be positioned on the second buffer layer BUF2. Here, the second buffer layer BUF2 may be positioned higher than the first buffer layer BUF1.

The first active layer ACT1 of the first transistor TFT1 may be disposed on the first buffer layer BUF1, and a first gate insulating layer GI1 may be disposed on the first active layer ACT1 of the first transistor TFT1. A first gate electrode G1 of the first transistor TFT1 may be disposed on the first gate insulating layer GI1, and a first interlayer insulating layer ILD1 may be disposed on the first gate electrode G1 of the first transistor TFT1.

The first active layer ACT1 of the first transistor TFT1 may include a first channel region overlapping the first gate electrode G1, a first source connection area located on one side of the first channel area, and a first drain connection area located on the opposite side of the channel area.

A second buffer layer BUF2 may be disposed on the first interlayer insulating layer ILD1.

The second active layer ACT2 of the second transistor TFT2 may be disposed on the second buffer layer BUF2, and a second gate insulating layer GI2 may be disposed on the second active layer ACT2. A second gate electrode G2 of the second transistor TFT2 may be disposed on the second gate insulating layer GI2, and a second interlayer insulating layer ILD2 may be disposed on the second gate electrode G2.

The second active layer ACT2 of the second transistor TFT2 may include a second channel area overlapping the second gate electrode G2, a second source connection area located on one side of the second channel area, and a second drain connection area located on the opposite side of the second channel area.

The first source electrode S1 and the first drain electrode D1 of the first transistor TFT1 may be disposed on the second interlayer insulating layer ILD2. In addition, the second source electrode S2 and the second drain electrode D2 of the second transistor TFT2 may be disposed on the second interlayer insulating layer ILD2.

The first source electrode S1 and the first drain electrode D1 of the first transistor TFT1 may be electrically connected to the first source connection area and the first drain connection area of the first active layer ACT1, respectively, through the via holes in the second interlayer insulating layer ILD2, the second gate insulating layer GI2, the second buffer layer BUF2, the first interlayer insulating layer ILD1, and the first gate insulating layer GI1.

The second source electrode S2 and the second drain electrode D2 of the second transistor TFT2 may be electrically connected to the second source connection area and the second drain connection area of the second active layer ACT2, respectively, through the via holes in the second interlayer insulating layer ILD2 and the second gate insulating layer GI2.

A storage capacitor Cst may include a first capacitor electrode PLT1 and a second capacitor electrode PLT2.

The first capacitor electrode PLT1 may be electrically connected to the second gate electrode G2 of the second transistor TFT2, and the second capacitor electrode PLT2 may be electrically connected to the second source electrode S2 of the second transistor TFT2.

A lower metal BML may be disposed below the second active layer ACT2 of the second transistor TFT2. The lower metal BML may overlap at least a portion or the entire second active layer ACT2.

For example, the lower metal BML may be electrically connected to the second gate electrode G2. In another example, the lower metal BML may function as a light shield to block light incident from below. In this case, the lower metal BML may be electrically connected to the second source electrode S2.

For example, the first transistor TFT1 may be a driving transistor for driving the light-emitting device ED, and the second transistor TFT2 may be a scan transistor or a light-emission control transistor. However, as shown in FIG. 6, the first transistor TFT1 may be a scan transistor or a light-emission control transistor, and the second transistor TFT2 may be a driving transistor for driving the light-emitting device ED. Here, the light-emission control transistor is a transistor that controls the connection between the driving transistor and the light-emitting device according to a light-emission control signal, thereby controlling whether the light-emitting device emits light.

The display panel 110 may include a planarization layer PLN disposed on the first transistor TFT1 and the second transistor TFT2.

For example, the planarization layer PLN may include a first planarization layer PLN1. The first planarization layer PLN1 may be disposed on the first source electrode S1 and the first drain electrode D1 of the first transistor TFT1, and on the second source electrode S2 and the second drain electrode D2 of the second transistor TFT2.

A relay electrode RE may be disposed on the first planarization layer PLN1. The relay electrode RE may electrically connect the second source electrode S2 of the second transistor TFT2 and the pixel electrode PE of the light-emitting device ED. In one example, the relay electrode RE may be electrically connected to the first drain electrode D1 or the first source electrode S1 of the first transistor TFT1 through a hole in the first planarization layer PLN1. In another example, the relay electrode RE may be electrically connected to the second source electrode S2 or the second drain electrode D2 of the second transistor TFT2 through a hole in the first planarization layer PLN1.

The planarization layer PLN disposed in the display panel 110 may further include a second planarization layer PLN2 on the first planarization layer PLN1. For example, the second planarization layer PLN2 may be disposed while covering the relay electrode RE positioned on the first planarization layer PLN1.

Referring to FIG. 6, a light-emitting device formation unit may be positioned on the second planarization layer PLN2 and may include a pixel electrode PE, an intermediate layer EL, and a common electrode CE for forming the light-emitting device ED.

The light-emitting device ED may be configured in a region where the pixel electrode PE, the intermediate layer EL, and the common electrode CE overlap.

The pixel electrode PE may be disposed on the second planarization layer PLN2. The pixel electrode PE may be connected to the relay electrode RE through a hole in the second planarization layer PLN2.

A bank BK may be disposed on the pixel electrode PE.

The bank BK may include a bank hole, through which a portion of the pixel electrode PE may be exposed. That is, the bank hole formed in the bank BK may overlap a portion of the pixel electrode PE. The bank BK may include a black pigment. For example, the bank BK may include an organic material containing a black pigment.

The intermediate layer EL may be disposed on the bank BK. The intermediate layer EL may contact a portion of the pixel electrode PE through the bank hole.

At least one spacer SPCR may be present between the intermediate layer EL and the bank BK.

The common electrode CE may be disposed on the intermediate layer EL. The common electrode CE may include a common electrode hole CH. The common electrode hole CH formed in the common electrode CE may be disposed in the first display area DA1. A single common electrode hole CH may be positioned between two adjacent emission areas EA.

The common electrode CE may be disposed in the emission area EA included in the normal area NA and the first display area DA1. However, the common electrode CE may not be disposed in the transmissive area TA within the first display area DA1. That is, the transmissive area TA within the first display area DA1 may correspond to the common electrode hole CH, which is an opening of the common electrode CE.

When the transmittance of the first optical area OA1 and the transmittance of the second optical area OA2 are the same, the stacked structure of the first transmissive area TA1 in the first optical area OA1 may be completely identical to the stacked structure of the second transmissive area TA2 in the second optical area OA2.

When the transmittance of the first optical area OA1 and the transmittance of the second optical area OA2 are different, the stacked structure of the first transmissive area TA1 in the first optical area OA1 may be partially different from the stacked structure of the second transmissive area TA2 in the second optical area OA2. For example, at least one of an encapsulation layer ENCAP, a touch sensor layer TSL, and a planarization layer PLN, which will be described later, may be removed in the first transmissive area TA1 of the first optical area OA1. For example, the distance from the substrate SUB to the top surface of the first transmissive area TA1 in the first optical area OA1 may be smaller than the distance from the substrate SUB to the top surface of the second transmissive area TA2 in the second optical area OA2.

Referring to FIG. 6, the encapsulation unit may be positioned on the common electrode CE. The encapsulation unit may include an encapsulation layer ENCAP formed on the common electrode CE.

The encapsulation layer ENCAP may prevent moisture or oxygen from penetrating into the light-emitting device ED. In particular, the encapsulation layer ENCAP may prevent moisture or oxygen from penetrating into the intermediate layer EL, which may include an organic layer. Here, the encapsulation layer ENCAP may be formed as a single layer or as multiple layers.

The encapsulation layer ENCAP may include a first encapsulation layer PAS1, a second encapsulation layer PCL, and a third encapsulation layer PAS2. For example, the first encapsulation layer PAS1 and the third encapsulation layer PAS2 may be inorganic layers (inorganic encapsulation layers), and the second encapsulation layer PCL may be an organic layer (organic encapsulation layer). Since the second encapsulation layer PCL is formed as an organic layer, it may also function as a planarization layer.

Referring to FIG. 6, when the touch sensor TS is of a type embedded in the display panel 110, a touch sensor layer TSL may be disposed on the encapsulation layer ENCAP. The structure of the touch sensor layer TSL and the touch sensor TS will be described in detail below.

The touch sensor layer TSL may include a touch sensor metal TSM and bridge metals BRG, and may further include insulating layer structures such as a sensor buffer layer S-BUF, a sensor interlayer insulating layer S-ILD, and a sensor protective layer S-PAC. Here, the sensor interlayer insulating layer S-ILD may include one or more insulating layers.

The sensor buffer layer S-BUF may be disposed on the encapsulation layer ENCAP. The bridge metals BRG may be disposed on the sensor buffer layer S-BUF, and the sensor interlayer insulating layer S-ILD may be disposed on the bridge metals BRG. Here, the sensor buffer layer S-BUF may be omitted.

The touch sensor TS may include a touch sensor metal TSM and a bridge metal BRG, which are positioned on different layers.

The touch sensor metal TSM may be disposed on the sensor interlayer insulating layer S-ILD.

A plurality of touch sensor metals TSM may form a single touch electrode (or a single touch electrode line) and may be arranged in a mesh structure while being electrically connected.

A portion of the touch sensor metal TSM and another portion of the touch sensor metal TSM may be electrically connected via the bridge metal BRG to form a single touch electrode (or a single touch electrode line).

For example, the touch sensor metal TSM may include a first touch sensor metal TSM, a second touch sensor metal TSM, and a third touch sensor metal TSM, which are arranged adjacent to each other. If the third touch sensor metal TSM is positioned between the first touch sensor metal TSM and the second touch sensor metal TSM, and the first touch sensor metal TSM and the second touch sensor metal TSM need to be electrically connected, they may be electrically connected via the bridge metal BRG positioned on a different layer. The bridge metal BRG may be insulated from the third touch sensor metal TSM by the sensor interlayer insulating layer S-ILD.

When the touch sensor TS is formed in the display panel 110, chemicals (such as developer or etchant) used in the manufacturing process or moisture from external sources may be present. By disposing the touch sensor TS on the sensor buffer layer S-BUF, penetration of chemicals or moisture into the light-emitting layer EL, which includes an organic material, during the manufacturing process of the touch sensor TS may be prevented. Accordingly, the sensor buffer layer S-BUF may prevent damage to the light-emitting layer EL, which is vulnerable to chemicals or moisture.

The sensor buffer layer S-BUF may be formed of an organic insulating material that has a low dielectric constant of 1 to 3 and may be formed at a low temperature of a certain temperature (e.g., 100°C) or lower, in order to prevent damage to the light-emitting layer EL, which includes an organic material vulnerable to high temperatures.

For example, the sensor buffer layer S-BUF may be formed of a material from an acrylic series, an epoxy series, or a siloxane series. Due to bending of the display device 100, the encapsulation layer ENCAP may be damaged, and the touch sensor metal positioned on the sensor buffer layer S-BUF may crack. Even when the display device 100 is bent, the sensor buffer layer S-BUF, which has planarization properties due to being formed of an organic insulating material, may prevent damage to the encapsulation layer ENCAP and/or cracking of the metals TSM and BRG forming the touch sensor TS. However, the present disclosure is not limited thereto. For example, the sensor buffer layer S-BUF may be formed of an inorganic insulating material such as silicon nitride (SiNx) or silicon oxide (SiOx).

A sensor protective layer S-PAC may be disposed to cover the touch sensor TS. The sensor protective layer S-PAC may be an organic insulating film.

The touch sensor metal TSM and the bridge metals BRG may be disposed in the low-transmittance area LTA of the first display area DA1. The touch sensor metal TSM and the bridge metals BRG may not be disposed in the transmissive area TA of the first display area DA1. The touch sensor metal TSM and the bridge metals BRG may be arranged so as not to overlap with the emission area EA in the low-transmittance area LTA.

In the display area DA, at least a portion of the touch sensor metal TSM positioned on the encapsulation layer ENCAP may extend along the outer inclined surface of the encapsulation layer ENCAP and be electrically connected to a pad located further outward than the outer inclined surface of the encapsulation layer ENCAP. Here, the pad may be disposed in the non-display area NDA and may be a metal pattern electrically connected to the touch driving circuit 260.

In the transmissive area TA, common electrode CE may include a common electrode hole CH. The common electrode hole CH may overlap with the transmissive area TA.

Additionally, in the transmissive area TA, a hole may be formed in the bank BK. That is, the bank BK may have a hole overlapping with the transmissive area TA.

At least a portion of the first display area DA1 may overlap with the electronic device 10. The electronic device 10 may be the first electronic device 11 and/or the second electronic device 12.

The first electronic device 11 and/or the second electronic device 12 may receive light transmitted through the optical area OA and perform a predetermined operation.

The touch sensor metal TSM may be disposed in the emission area EA of the first display area DA1, while the touch sensor metal TSM may not be disposed in the transmissive area TA of the optical area OA.

Since the whole or a part of the optical area OA overlaps with the first electronic device 11 and/or the second electronic device 12, for proper touch recognition in the optical area OA and normal operation of the first electronic device 11 and/or the second electronic device 12, it is necessary to place the touch sensor metal TSM in the optical area OA while not reducing the light transmittance in the optical area OA.

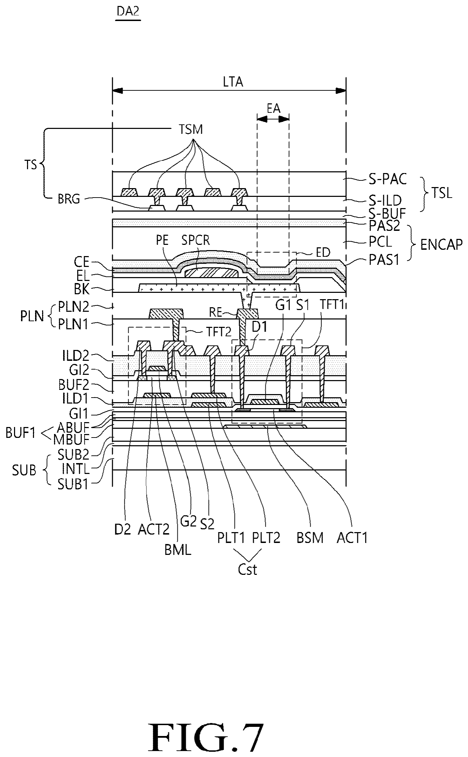

FIG. 7 is a cross-sectional view of the second display area DA2 of the display panel 110 according to embodiments of the present disclosure.

Referring to FIG. 6 and FIG. 7, the stacked structure of the second display area DA2 may be identical to the stacked structure of the low-transmittance area LTA in the first display area DA1. Accordingly, descriptions of identical layers may be omitted.

The first display area DA1 is an area where the optical transmission structure and the transmissive area TA must be formed, whereas the second display area DA2 is an area where the optical transmission structure and the transmissive area TA do not need to be formed.

That is, the entire second display area DA2 may be a low-transmittance area LTA, and the second display area DA2 may not include a transmissive area TA.

Accordingly, the second display area DA2 may not overlap with the first electronic device 11 and/or the second electronic device 12, which receive light transmitted through the display panel 110 and perform a predetermined operation using the received light.

Conversely, since the first display area DA1 may overlap with the first electronic device 11 and/or the second electronic device 12, which receive light transmitted through the display panel 110 and perform a predetermined operation using the received light, an optical transmission structure must be formed.

That is, in at least one of the optical areas OA1 and OA2 included in the first display area DA1, both an image display structure and an optical transmission structure must be formed.

Since the whole or a part of the optical area OA overlaps with the first electronic device 11 and/or the second electronic device 12, for proper touch recognition in the optical area OA and normal operation of the first electronic device 11 and/or the second electronic device 12, it is necessary to place the touch sensor metal TSM in the optical area OA while not reducing the light transmittance in the optical area OA.

The embodiments of the present disclosure may provide a display device 100 in which the touch sensor metal TSM is placed in the optical area OA of the first display area DA1 to achieve a touch performance that is the same or substantially the same as in the second display area DA2, which is the normal area NA, while improving disadvantages that may arise from this placement.

Hereinafter, the touch electrode TE and the touch sensor metal TSM arranged in the display panel 110 according to embodiments of the present disclosure will be described in detail.

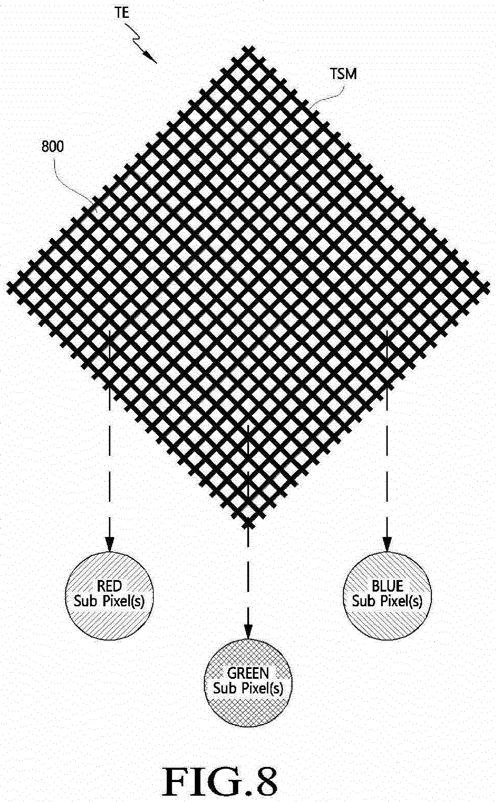

FIG. 8 is a diagram illustratively showing the touch electrode TE arranged in the display panel 110 according to embodiments of the present disclosure.

Referring to FIG. 8, a single touch electrode TE may be of a mesh type having a plurality of opening areas 800. That is, a single touch electrode TE may be a patterned touch sensor metal TSM in a mesh type so as to have a plurality of opening areas 800.

Each of the plurality of opening areas 800 in a single touch electrode TE may correspond to an emission area of at least one sub-pixel SP. That is, the plurality of opening areas 800 may form a path through which light emitted from the plurality of sub-pixels SP arranged below passes upward.

Referring to FIG. 8, each of the opening areas 800 of the touch sensor metal TSM present in the area of the touch electrode TE, which is a mesh-type patterned touch sensor metal TSM, may correspond to an emission area EA of at least one sub-pixel SP.

For example, each of the plurality of opening areas 800 present in the area of a single touch electrode TE may correspond to at least one emission area EA of red sub-pixels, green sub-pixels, and blue sub-pixels.

In another example, each of the plurality of opening areas 800 present in the area of a single touch electrode TE may correspond to at least one emission area EA of red sub-pixels, green sub-pixels, blue sub-pixels, and white sub-pixels.

When viewed in a plane, since at least one emission area EA of a sub-pixel is present in each opening area 800 of each touch electrode TE, it is possible to enable touch sensing while also increasing the aperture ratio and emission efficiency of the display panel 110.

As described above, the approximate outer contour of a single touch electrode TE may be a rhombus or a rectangle, and the opening areas 800 of the touch electrode TE may also be a rhombus or a rectangle. However, the present disclosure is not limited thereto.

In the touch electrode TE, the actual touch sensor metal TSM, excluding the plurality of opening areas 800, may be positioned on and overlap with the bank BK.

Such an arrangement may be applied in the second display area DA2, whereas in the first optical area OA1 and/or the second optical area OA2 of the first display area DA1, the touch sensor metal TSM may not be placed to improve transmittance.

This is because an optical transmission structure must be formed in the first optical area OA1 to transmit light to the first electronic device 11 and in the second optical area OA2 to transmit light to the second electronic device 12.

However, if the touch sensor metal TSM is not placed in the first optical area OA1 and/or the second optical area OA2, a visibility difference may occur between areas with and without the touch sensor metal TSM, and luminance variation depending on the viewing angle may occur.

Additionally, if there are areas where the touch sensor metal TSM is not placed at all, the resistance of the touch sensor metal TSM may increase, and the capacitance may decrease, leading to a disadvantage where the overall touch performance in the display area DA deteriorates.

Accordingly, to solve these issues, the inventors have devised a display device 100 that includes a touch sensor metal TSM in the first optical area OA1 and/or the second optical area OA2 to maintain touch performance in the optical area OA while also having an optical transmission structure that allows the first electronic device 11 and/or the second electronic device 12 arranged below the display panel 110 to normally receive light.

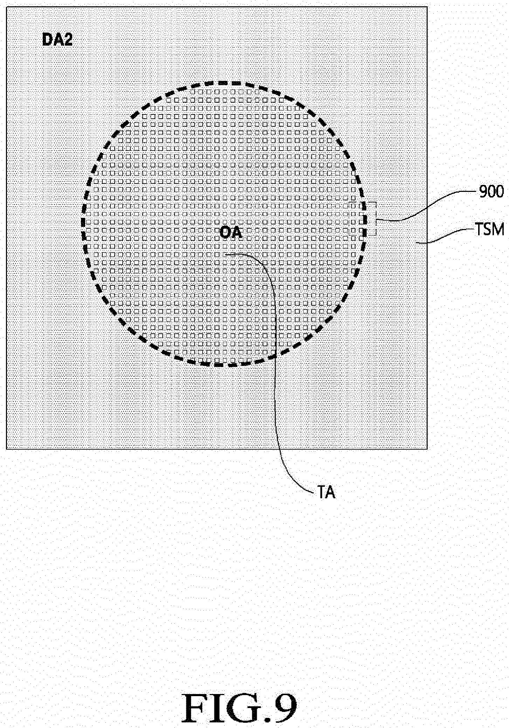

Hereinafter, the arrangement structure of the touch sensor metal TSM according to embodiments of the present disclosure will be described in detail with reference to FIG. 9 to FIG. 12.

FIG. 9 is a plan view illustrating the arrangement of the touch sensor metal TSM according to embodiments of the present disclosure.

Hereinafter, the first optical area OA1 and/or the second optical area OA2 may be referred to as the optical area OA.

Hereinafter, the first electronic device 11 and/or the second electronic device 12 may be referred to as the electronic device 10.

The second display area DA2, which does not include the optical area OA, may be a low-transmittance area LTA that does not include a transmissive area TA.

In contrast, the optical area OA may include both a transmissive area TA and a low-transmittance area LTA.

The low-transmittance area LTA may be an area in the optical area OA excluding the plurality of transmissive areas TA. The low-transmittance area LTA may include a plurality of emission areas EA.

The display device 100 according to embodiments of the present disclosure may include a specifically patterned touch sensor metal TSM in the optical area OA to provide a touch sensing function for detecting the presence of touch and/or touch coordinates while maintaining the transmissive area TA for an optical transmission structure.

In this case, the touch sensor metal TSM with a specific pattern may have an opening overlapping with the transmissive area TA in the optical area OA.

In the transmissive area TA, a common electrode hole CH may be formed in the common electrode CE. That is, the common electrode hole CH may overlap with the transmissive area TA.

In this case,, the shape of the common electrode hole CH may be various, such as circular, elliptical, rectangular, hexagonal, or octagonal.

The arrangement of the common electrode holes CH may be either regular or irregular.

In one example, when the arrangement of the common electrode holes CH is regular, the spacing between a first common electrode hole CH and a second common electrode hole CH, which are adjacent, may be the same or substantially the same as the spacing between the second common electrode hole CH and a third common electrode hole CH, which are adjacent.

In another example, when the arrangement of the common electrode holes CH is irregular, the spacing between a first common electrode hole CH and a second common electrode hole CH, which are adjacent, may be different from the spacing between the second common electrode hole CH and a third common electrode hole CH, which are adjacent.

To pattern the common electrode CE, a metal patterning layer MPL may be disposed in the common electrode hole CH.

In the area overlapping with the transmissive area TA, the metal patterning layer MPL may serve as an electron injection layer EIL. The metal patterning layer MPL serving as an electron injection layer EIL in the common electrode hole CH and the layer serving as an electron injection layer EIL in the area where the common electrode hole CH is not formed (e.g., the electron injection layer EIL of the intermediate layer EL) may be composed of different materials.

On the other hand, the metal patterning layer MPL may include a common electrode patterning material.

For example, when the common electrode CE is a cathode, the common electrode patterning material included in the metal patterning layer MPL may be a cathode patterning material. For example, the metal patterning layer MPL may include a fluorine-based compound or an organic material. The process of forming the common electrode hole CH involves first forming the metal patterning layer MPL. The metal patterning layer MPL may have various shapes such as circular, elliptical, or octagonal. After forming the metal patterning layer MPL, the common electrode CE may be deposited. The common electrode CE may be deposited over the entire front surface of the display device 100. During this deposition process, the common electrode CE may not be deposited in regions overlapping with the metal patterning layer MPL. Accordingly, in the regions where the metal patterning layer MPL is formed, the common electrode CE may not be present, meaning that these regions correspond to the common electrode holes CH. Thus, the common electrode CE may include the common electrode holes CH.

If the touch sensor metal TSM is placed over the transmissive area TA, which overlaps with the common electrode hole CH, it may block light transmission in the transmissive area TA. To ensure that the electronic device 10 located below the substrate can properly receive light, it is advantageous to arrange openings in the touch sensor metal TSM over the transmissive area TA.

Conversely, in the second display area DA2, where no transmissive area TA is present, the touch sensor metal TSM may not have openings overlapping with a transmissive area TA.

Hereinafter, a detailed description is provided regarding the touch sensor metal TSM arranged in a specific pattern in the optical area OA of the first display area DA1.

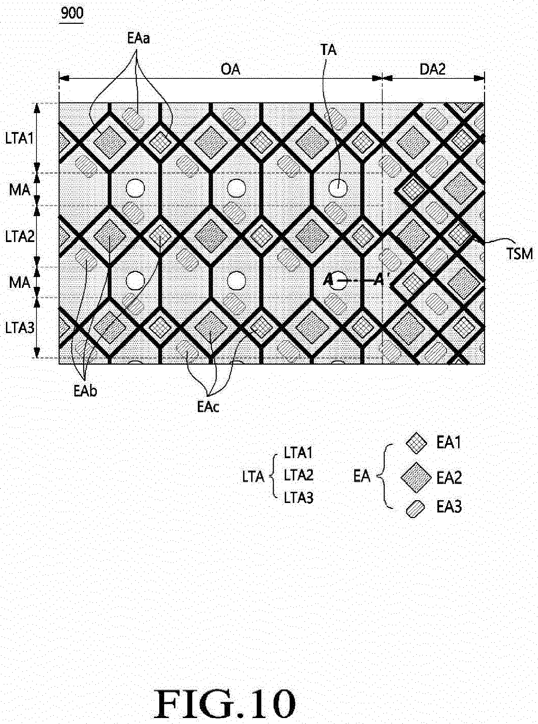

FIG. 10 is an enlarged plan view of region 900 in FIG. 9, illustrating the touch sensor metal TSM arranged in the optical area OA (for example, a first touch sensor metal) and the second display area DA2 (for example, a second touch sensor metal).

By arranging the touch sensor metal TSM in both the optical area OA included in the first display area DA1 and the second display area DA2 disposed outside the first display area DA1, touch functionality can be enabled across the entire display area DA.

In this case, the low-transmittance area LTA within the optical area OA may include a first low-transmittance area LTA1 in which a plurality of first emission areas EAa are arranged, a second low-transmittance area LTA2 spaced apart from the first low-transmittance area LTA1 and in which a plurality of second emission areas EAb are arranged, and a third low-transmittance area LTA3 spaced apart from the second low-transmittance area LTA2 and in which a plurality of third emission areas EAc are arranged.

The optical area OA may further include an intermediate area MA disposed between the first low-transmittance area LTA1 and the second low-transmittance area LTA2, and between the second low-transmittance area LTA2 and the third low-transmittance area LTA3. The intermediate area MA may include at least one transmissive area TA.

The low-transmittance area LTA may include an emission area EA.

The plurality of emission areas EA may include a first color emission area EA1 that emits first-color light, a second color emission area EA2 that emits second-color light, and a third color emission area EA3 that emits third-color light.

At least one of the first color emission area EA1, the second color emission area EA2, and the third color emission area EA3 may have a different area from the others. The first, second, and third colors may be different and may include various colors. For example, the first color, second color, and third color may include red, green, and blue.

If the touch sensor metal TSM is placed over the emission area EA, it may block the emitted light from the emission area, leading to visibility issues. Accordingly, it is preferable not to place the touch sensor metal TSM over the emission area EA.

Accordingly, the touch sensor metal TSM according to embodiments of the present disclosure may have openings that overlap with the first color emission area EA1, the second color emission area EA2, and the third color emission area EA3.

That is, when viewed in plan view, each of the openings 800 of the touch sensor metal TSM has at least one sub-pixel emission area, enabling touch sensing while also improving the light-emitting efficiency of the display panel 110.

In addition, if the touch sensor metal TSM is placed over the transmissive area TA, it may block light transmission in the transmissive area TA. To ensure that the electronic device 10 located below the substrate SUB can properly receive light, it is preferable that the touch sensor metal TSM is not placed over the transmissive area TA.

Accordingly, the touch sensor metal TSM according to embodiments of the present disclosure may have a first opening overlapping with the first color emission area EA1, a second opening overlapping with the second color emission area EA2, and a third opening overlapping with the third color emission area EA3 or further overlapping with the transmissive area TA, wherein at least one of the first opening, the second opening, and the third opening may have a different size from the others, for example, the first opening may have a different size from that of the second opening.

In this case, one portion of the touch sensor metal TSM may be connected to another portion of the touch sensor metal TSM.

Additionally, the width of the touch sensor metal TSM surrounding each opening may be different from each other.

In one example, the width of the portion of the touch sensor metal TSM disposed at the boundary between the first opening and the third opening may be different from the width of the portion disposed at the boundary between the third openings.

In another example, the width of the portion of the touch sensor metal TSM disposed at the boundary between the second opening and the third opening may be different from the width of the portion disposed at the boundary between the third openings. In yet another example, the width of the touch sensor metal TSM adjacent to the transmissive area TA within the optical area OA may be relatively narrower than the width of the touch sensor metal TSM positioned farther from the transmissive area TA.

The width of the touch sensor metal TSM disposed in the second display area DA2 may be different from the width of the touch sensor metal TSM disposed in the optical area OA. For example, the width of the touch sensor metal TSM disposed in the second display area DA2 may be smaller than the width of the touch sensor metal TSM disposed in the optical area OA. Since the density of the touch sensor metal TSM placed in the optical area OA is lower than that in the second display area DA2, the width of the touch sensor metal TSM in the optical area OA may be larger than the width of the touch sensor metal TSM in the second display area DA2 to improve touch sensor TS performance.

Additionally, one portion of the touch sensor metal TSM may be spaced apart from another portion of the touch sensor metal TSM by the third opening.

The touch sensor metal TSM according to embodiments of the present disclosure may include a first portion disposed in the first low-transmittance area LTA1 and having a plurality of openings overlapping with a plurality of first emission areas EAa, a second portion disposed in the second low-transmittance area LTA2 and having a plurality of openings overlapping with a plurality of second emission areas EAb, and a third portion disposed in the intermediate area MA, connecting the first portion and the second portion and having a plurality of openings overlapping with the transmissive area TA. The first portion, second portion, and third portion may be connected in a mesh structure.

That is, in the optical area OA, the touch sensor metal TSM may be patterned in a mesh type to connect each portion.

In this case, the first portion and the second portion of the touch sensor metal TSM may be connected in a line shape. Additionally, at least one signal line (SL1, SL2) may include a wiring part disposed parallel to the line-shaped touch sensor metal TSM and may at least partially overlap with the line-shaped touch sensor metal TSM. For example, at least one signal line (SL1, SL2) may include a wiring part disposed parallel to the third portion and at least partially overlapping the third portion.

Since no transmissive area TA is formed in the second display area DA2, the touch sensor metal TSM according to embodiments of the present disclosure may have openings overlapping with the emission area EA in the second display area DA2 but may not have openings overlapping with the transmissive area TA.

In other words, the openings of the touch sensor metal TSM disposed in the second display area DA2 (i.e., the second touch sensor metal) may include at least one opening having a different size from the openings of the touch sensor metal TSM disposed in the optical area OA (i.e., the first touch sensor metal).

By arranging the touch sensor metal TSM in this manner, normal touch operation may be possible even in the optical area OA, which is included in the display area DA of the display panel 110 and overlaps with an optical electronic device.

Furthermore, since the touch sensor metal TSM is also arranged in the optical area OA, there is no luminance variation between regions with and without the touch sensor metal TSM, thereby improving visibility.

Hereinafter, the vertical structure of the touch sensor metal TSM arrangement according to embodiments of the present disclosure will be described.

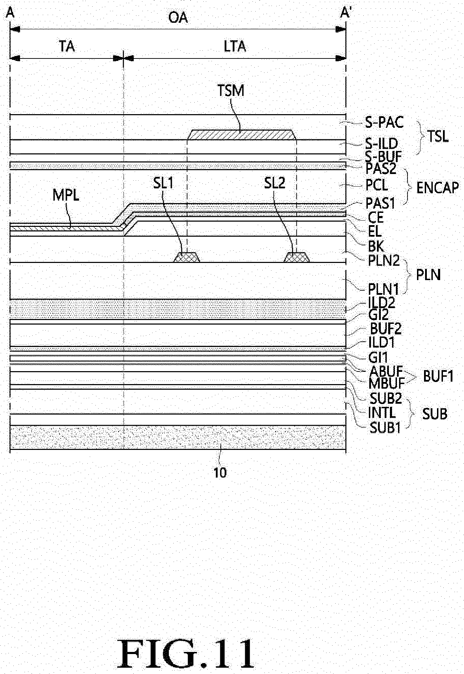

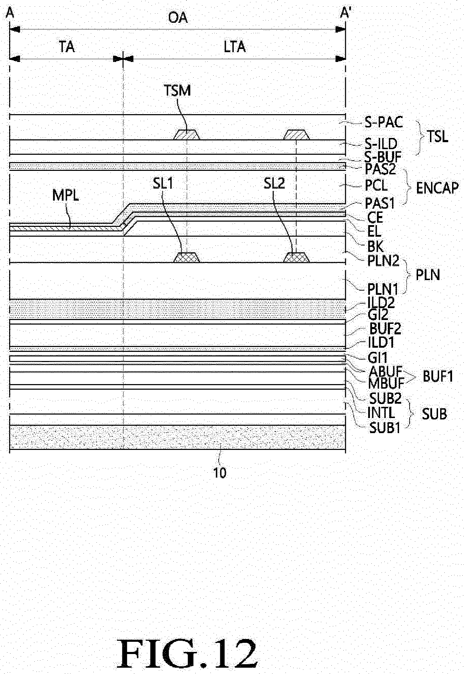

FIG. 11 and FIG. 12 are cross-sectional views of the display panel 110 taken along the A-A' line in FIG. 10, corresponding to the optical area OA.

Since the layer structure in FIG. 11 and FIG. 12 is the same as that in FIG. 6, a redundant description will be omitted.

The optical area OA may include a transmissive area TA and a low-transmittance area LTA.

The low-transmittance area LTA may allow light to pass through at a lower transmittance than the transmissive area TA, but it is not an area that completely blocks light.

Various insulating layers may be disposed on the substrate SUB. These insulating layers may form transistors and capacitors included in the sub-pixels SP and may serve as insulating layers for forming various signal lines (SL1, SL2).

For example, the insulating layers may include a first buffer layer BUF1, a first gate insulating layer GI1, a first interlayer insulating layer ILD1, a second buffer layer BUF2, a second gate insulating layer GI2, a second interlayer insulating layer ILD2, a first planarization layer PLN1, a second planarization layer PLN2, and a bank BK.

For example, the signal lines (SL1, SL2) may include data lines DL, gate lines GL, and/or power supply lines.

Various metal layers may be disposed between the insulating layers on the substrate SUB, and these metal layers may be used to form various signal lines (SL1, SL2). In this case, the plurality of signal lines (SL1, SL2) may include a first signal line SL1 and a second signal line SL2.

The signal lines (SL1, SL2) may be disposed on the first planarization layer PLN1.

The signal lines (SL1, SL2) may include the same material as the relay electrode RE, which electrically connects a source electrode or a drain electrode to a pixel electrode PE.

The common electrode CE may be disposed in the low-transmittance area LTA.

However, in the transmissive area TA, the common electrode CE may not be disposed, and a common electrode hole CH may be formed.

Similarly, to improve the light transmittance in the transmissive area TA, the signal lines (SL1, SL2), pixel electrodes PE, transistors TFT, and touch sensor metal TSM may not be disposed in the transmissive area TA but instead may be disposed in the low-transmittance area LTA.

However, light transmission may still occur in the low-transmittance area LTA, and this light transmission may be obstructed by metals such as the touch sensor metal TSM and the signal lines (SL1, SL2).

For example, when light transmission occurs in the low-transmittance area LTA, a diffraction phenomenon may occur due to the gap between metals within the insulating layers. The diffraction phenomenon refers to the spreading of waves when light waves pass through an obstacle or a narrow slit.

For instance, when light emitted from the light-emitting device ED in the optical area OA for image display exits to the front of the display panel 110, if the touch sensor metals TSM in the optical area OA are spaced apart, the gap between the touch sensor metals TSM may cause diffraction of the light passing through the optical area OA to the front of the display panel 110.

However, according to embodiments of the present disclosure, in the optical area OA, the touch sensor metals TSM are arranged to surround the light-emitting devices ED without overlapping them, thereby reducing light diffraction while still forming the touch sensor structure in the optical area OA.

In another example, when light incident on the upper surface of the display panel 110 (e.g., infrared light or light for a camera) passes through the optical area OA and exits the back of the display panel 110, if metals such as the signal lines (SL1, SL2) are spaced apart, the gap between these metals may cause light diffraction as the light passes through the optical area OA.

However, according to embodiments of the present disclosure, by arranging the touch sensor metal TSM to overlap with the spacing between the signal lines (SL1, SL2) in the low-transmittance area LTA, light diffraction that may occur between the signal lines (SL1, SL2) can be reduced.

That is, referring to FIG. 11 and FIG. 12, by arranging the touch sensor metal TSM to overlap with the signal lines (SL1, SL2), interference caused by metals can be minimized when light is transmitted through the low-transmittance area LTA.

Referring to FIG. 11, the display device 100 according to embodiments of the present disclosure may prevent light diffraction due to gap between the plurality of signal lines (SL1, SL2) in the low-transmittance area LTA. In this case, the display device 100 may include the touch sensor metal TSM overlapping with a portion of the first signal line SL1 and a portion of the second signal line SL2 in the low-transmittance area LTA.

Since light transmission in the low-transmittance area LTA may be obstructed by metals such as the touch sensor metal TSM and the signal lines (SL1, SL2), referring to FIG. 12, in the display device 100 according to embodiments of the present disclosure, by arranging the touch sensor metal TSM to overlap with the signal lines (SL1, SL2), interference with light transmission due to metals can be minimized. The width of each of the plurality of signal lines (SL1, SL2) may be smaller than the width of the touch sensor metal TSM.

Referring to FIG. 12, the touch sensor metal TSM may be arranged such that its center overlaps with the center of the signal lines (SL1, SL2). However, the present disclosure is not limited thereto.

In this case, at least one signal line (SL1, SL2) may include a data line DL.

Additionally, a bank BK may be disposed on the pixel electrode PE, and the signal lines such as the first signal line SL1 and the second signal line SL2 may overlap with the bank BK.

The display device 100 according to embodiments of the present disclosure may include an electronic device 10 that is located below the substrate SUB, overlaps with the optical area OA, and performs a predetermined operation using light.

For example, the display device 100 according to embodiments of the present disclosure may include a first electronic device 11 that is located below the substrate SUB, overlaps with the optical area OA, and performs a predetermined operation using light in a wavelength band different from the light emitted from the emission area EA in the display area DA.

In another example, the display device 100 according to embodiments of the present disclosure may further include a second electronic device 12 that is located below the substrate SUB, overlaps with the optical area OA, and performs a predetermined operation using light in a wavelength band that includes the light emitted from the emission area EA in the display area DA.

In this case, the first electronic device 11 may be an infrared sensor, and the second electronic device 12 may be a camera.

The optical area OA may include a first optical area and a second optical area. In this case, the size of the first optical area may be different from the size of the second optical area. For example, when the infrared sensor overlaps with the first optical area and the camera overlaps with the second optical area, the size of the first optical area may be smaller than the size of the second optical area.

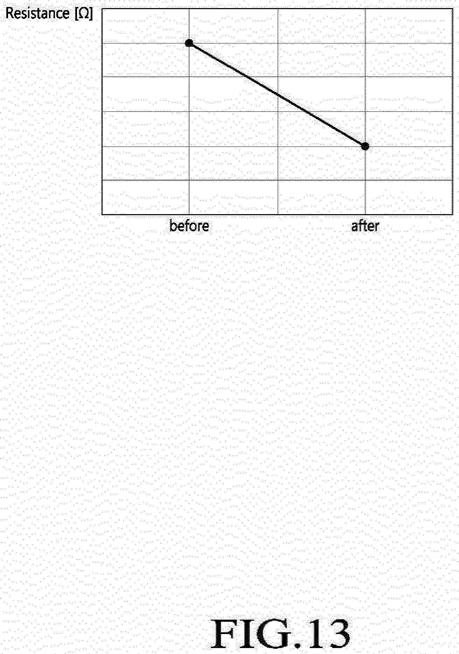

FIG. 13 illustrates the resistance change of the touch electrode TE before and after the touch sensor metal TSM is arranged in the optical area OA according to embodiments of the present disclosure.

Since resistance is proportional to the length of a conductor and inversely proportional to its cross-sectional area, increasing the arrangement of the touch sensor metal TSM in the optical area OA increases the cross-sectional area, which may result in a reduction in resistance.

Referring to FIG. 13, experimental results show that when the touch sensor metal TSM was arranged in the optical area OA according to embodiments of the present disclosure, a significant reduction in resistance was observed compared to before the arrangement.

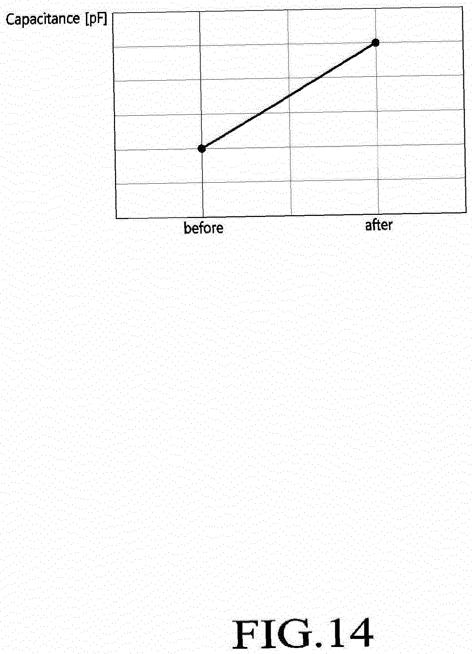

FIG. 14 illustrates the capacitance change of the touch electrode TE before and after the touch sensor metal TSM is arranged in the optical area OA according to embodiments of the present disclosure.

Since capacitance is inversely proportional to the thickness of the dielectric and proportional to the area of the dielectric, increasing the arrangement of the touch sensor metal TSM in the optical area OA increases the area, which may result in an increase in capacitance.

Referring to FIG. 14, experimental results show that when the touch sensor metal TSM was arranged in the optical area OA according to embodiments of the present disclosure, an increase in capacitance was observed compared to before the arrangement.

Thus, referring to FIG. 13 and FIG. 14, embodiments of the present disclosure may provide a display device that improves touch performance by reducing the resistance of the touch sensor metal and increasing capacitance.

Additionally, by reducing the resistance of the touch sensor metal and increasing the capacitance, the mobility may be improved, enabling low-power operation of the display device.

The arrangement of the touch sensor metal described above may be applied to both the first optical area OA1 and the second optical area OA2, where images can be displayed. That is, embodiments of the present disclosure may provide a display device that improves transmittance in the first optical area OA1 and/or the second optical area OA2 while arranging signal lines necessary for display driving in the optical area requiring light transmission, thereby allowing an optical electronic device overlapping with the optical area to normally receive light transmitted through the optical area.

Hereinafter, another example will be described in detail, in which a touch sensor metal arrangement is applied to a display device that has holes formed in the area where the optical electronic device is arranged.

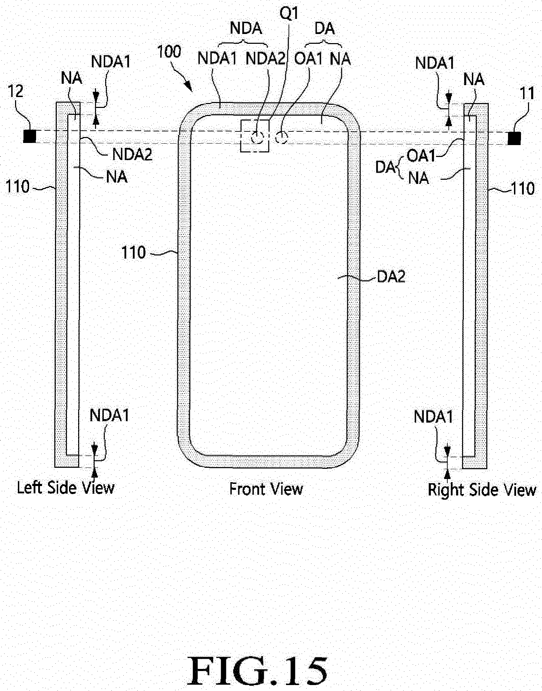

FIG. 15 is a plan view of the display device 100 according to embodiments of the present disclosure.

Referring to FIG. 15, the display panel 110 of the display device 100 may include a display area DA, where an image can be displayed, and a non-display area NDA, where no image is displayed.

One or more electronic devices 11, 12 may be separately provided and installed apart from the display panel 110 and may be electronic components located at the lower part (opposite the viewing side) of the display panel 110.

Light may enter the front (viewing side) of the display panel 110, pass through the display panel 110, and be delivered to one or more electronic devices 11, 12 located below the display panel 110 (on the opposite side of the viewing side). For example, the light passing through the display panel 110 may include visible light or infrared light.

The display area DA, which is an area where images can be displayed, may include a first optical area OA1 and a normal area NA. The normal area NA may be referred to as the second display area DA2, and the first optical area OA1 may have a light transmission structure.

The non-display area NDA, which is an area where images are not displayed, may include a first non-display area NDA1 (e.g., bezel area) and a second non-display area NDA2.

The second non-display area NDA2 may be arranged to be surrounded by the display area DA.

The second non-display area NDA2 may include a portion where the display panel 110 is omitted. In other words, a part of the second non-display area NDA2 may be penetrated in the thickness direction to form a sensor hole. In this case, the display device 100 according to embodiments of the present disclosure may be a display device 100 to which HiAA (Hole in Active Area) technology is applied. That is, the HiAA may be implemented as a region including a sensor hole.

At least a portion of the first optical area OA1 may overlap with the first electronic device 11, and at least a portion of the second non-display area NDA2 may overlap with the second electronic device 12.

For example, the first electronic device 11 may be a sensing sensor, and the second electronic device 12 may be a camera. The sensing sensor may be an infrared sensor that detects infrared light. Conversely, the first electronic device 11 may be a camera, and the second electronic device 12 may be a sensing sensor such as a proximity sensor or an ambient light sensor. That is, the electronic device arranged in the area where the sensor hole is formed may be either an infrared sensor or a camera.

The first optical area OA1 and the sensor hole may be arranged at the upper portion of the display area, as shown in FIG. 15, but are not limited thereto and may be arranged in various positions.

The first optical area OA1 may have various shapes, such as circular, elliptical, rectangular, hexagonal, or octagonal. The sensor hole may also have various shapes, such as circular, elliptical, rectangular, hexagonal, or octagonal. The first optical area OA1 and the sensor hole may have the same shape or different shapes.

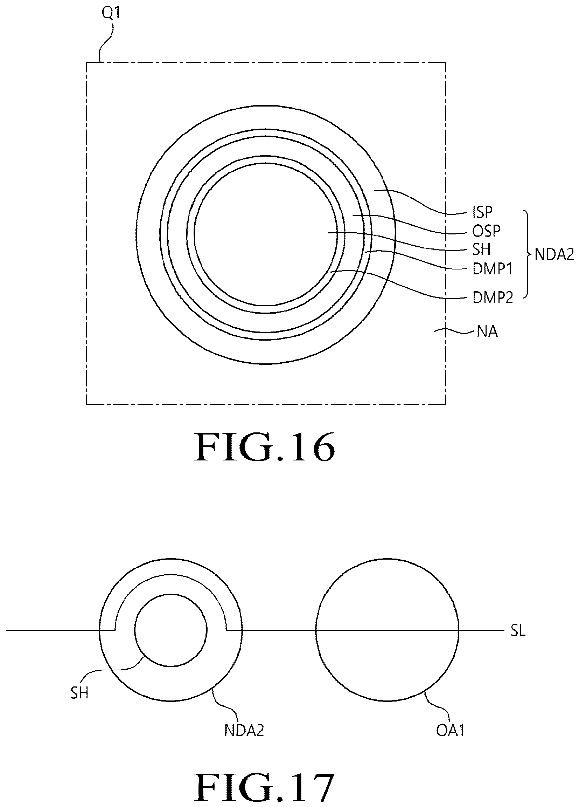

FIG. 16 is a plan view of the second non-display area NDA2, which is an enlarged view of region Q1 in FIG. 15.

The second non-display area NDA2 may be surrounded by the display area DA. For example, the second non-display area NDA2 may be surrounded by the normal area NA within the display area DA.

The second non-display area NDA2 may include an outer separation area OSP between the sensor hole SH and the normal area NA, a first dam area DMP1 between the outer separation area OSP and the normal area NA, an inner separation area ISP between the first dam area DMP1 and the normal area NA, and a second dam area DMP2 between the outer separation area OSP and the sensor hole SH. The second non-display area NDA2 may entirely surround the sensor hole SH.

However, in the sensor hole SH formed in the thickness direction, an end portion of an organic layer extending from the display area DA to the second non-display area NDA2 may be exposed. Here, the organic layer may refer to a portion of the intermediate layer EL of the light-emitting device ED in the display area DA extending to the second non-display area NDA2, which may include any one of the electron injection layer EIL, the electron transport layer ETL, the hole transport layer HTL and the hole injection layer HIL. In other words, the organic layer here may be a portion of the light-emitting device ED disposed in the display area DA extending to the second non-display area NDA2 and disposed on the outer separation area OSP, the first dam area DMP1, the inner separation area ISP, and the second dam area DMP2.

Therefore, a path from the end portion of the organic layer exposed via the sensor hole SH in the second non-display area NDA2 through the light-emitting layer EL in the display area DA to the light-emitting device ED may form a permeation path, causing moisture, oxygen, foreign substance to permeate into the light-emitting device ED through this path, thereby causing damage to the display device 100.

To delay and block the permeation of moisture, oxygen or foreign substance introduced from the outside, in the second non-display area NDA2, at least one overhang structure may be disposed on at least one of the outer separation area OSP and the inner separation area ISP, the organic layer may be disposed on the at least one overhang structure, and the organic layer may be cut off at both ends of the overhang structure to form a discontinuous pattern.

For example, a plurality of the overhang structures may be configured to be spaced apart from each other.

The overhang structure may have a predetermined thickness such that the organic layer in the second non-display area NDA2 can be effectively disconnected.

In addition, in the second non-display area NDA2, the organic layer may be further disposed on the first dam area DMP1 and the second dam area DMP2, which also have protruding shapes, to increase the length of the permeation path, thereby more effectively preventing the permeation.

The at least one overhang structure may include at least one of a planerization overhang (planerization tip, PT) structure and a metal overhang (metal tip, MT) structure. The PT structure may be formed of an organic material, and the MT structure may be formed of a metal material, such as a wire, a line, a metal layer, or the like, but is not limited thereto.

Specifically, the PT structure may be a portion of the planarization layer PLN (e.g., the second planarization layer PLN2) in the display area DA extending to the second non-display area NDA2. That is, the PT structure in the second non-display area NDA2 and the planarization layer PLN in the display area DA may be formed in the same layer and made of the same material (e.g., a planarization material), and the planarization material layer formed on the at least one of the outer separation area OSP and the inner separation area ISP of the second non-display area NDA2 is then patterned as a disconnected structure to form the PT structure.

On the other hand, the MT structure may be a portion of the relay electrode RE in the display area DA extending to the second non-display area NDA2. That is, the MT structure in the second non-display area NDA2 and the relay electrode RE in the display area DA may be formed in the same layer and made of the same material (e.g., a metal material), and the metal material layer formed on the at least one of the outer separation area OSP and the inner separation area ISP of the second non-display area NDA2 is then patterned as a disconnected structure to form the MT structure.

The sides of the overhang structure may be vertical or may have a tapered or reverse tapered shape, wherein an upper surface of the MT structure may be a curved surface.

Subsequently, the organic layer may be disposed on the PT structure or the MT structure, and the organic layer may be cut off at both ends of the PT structure or the MT structure by a patterning method to form a discontinuous organic pattern, thereby preventing permeation, and delaying permeation by the overhang height of the PT structure or the MT structure.

In another embodiment, the at least one overhang structure may include both the PT structure and the MT structure. For example, in the second non-display area NDA2, the PT structure may be formed on the MT structure, and the organic layer may be formed on the PT structure, such that the organic layer may be more effectively disconnected through the overall thickness of the PT structure and the MT structure.

The second electronic device 12 arranged in the area overlapping with the sensor hole SH may be either an infrared sensor or a camera.

The sensor hole SH may be an area where the display panel 110 is omitted. In other words, the display panel 110 may be penetrated in the thickness direction in the sensor hole SH.

When the display panel 110 includes such a hole, the touch sensor metal TSM according to embodiments of the present disclosure may not be arranged in the area overlapping with the sensor hole SH but may be arranged in an area excluding the sensor hole SH.

That is, the arrangement of the touch sensor metal TSM in the optical area OA, as shown in FIG. 10 to FIG. 12, may be applied to the first optical area OA1 in the display device 100 with the HiAA (Hole in Active Area) structure but may not be applied to the second non-display area NDA2 that includes the sensor hole SH. Hereinafter, reference will be made to FIG. 10 to FIG. 12 together.

According to embodiments of the present disclosure, in the first optical area OA1, the touch sensor metal TSM may be arranged so as not to overlap with the emission element ED and the transmissive area TA but to surround them, thereby reducing light diffraction while forming a touch sensor structure in the first optical area OA1.

From a vertical perspective, by arranging the touch sensor metal TSM to overlap with the gap between signal lines (SL1, SL2) in the low-transmittance area LTA of the first optical area OA1, light diffraction that may occur between the signal lines (SL1, SL2) may be reduced. That is, by arranging the touch sensor metal TSM to overlap with the signal lines (SL1, SL2), interference caused by metal when light is transmitted through the low-transmittance area LTA may be minimized.

FIG. 17 is an enlarged plan view of a second non-display area NDA2 and a first optical area OA1 in a display device 100 according to embodiments of the present disclosure.

Similarly, when light is transmitted through the second non-display area NDA2, the opening of the sensor hole SH must remain light-transmissive. Therefore, as shown in FIG. 17, in order to avoid interference caused by metal, the signal line SL and/or the power supply line (not shown), which bypasses through, passes through, or placed in the first optical area OA1 (UDIR), can be extended to the second non-display area NDA2 by bypassing the sensor hole SH disposed in the second non-display area NDA2.

In this case, the display device 100 according to embodiments of the present disclosure may include a touch sensor metal TSM that simultaneously overlaps with a portion of the first signal line SL1 and a portion of the second signal line SL2 in the low-transmittance area LTA of the first optical area OA1.

In addition, in the normal area NA, which may also be referred to as the second display area, the transmissive area TA is not formed. Accordingly, the touch sensor metal TSM according to embodiments of the present disclosure may include an opening overlapping with the emission area EA in the normal area NA but may not include an opening overlapping with the transmissive area TA.

The embodiments of the present disclosure described above may provide a display device that maintains touch performance in the optical area while having a light transmission structure that allows an optical electronic device arranged below the display panel to normally receive light.

A display device according to embodiments of the present disclosure may be described as follows.

Embodiments of the present disclosure may provide a display device including: a substrate including a display area capable of displaying an image, wherein the display area includes a first display area having a plurality of transmissive areas and a second display area positioned outside the first display area; a touch sensor metal disposed in the first display area and positioned outside the plurality of transmissive areas; a first signal line disposed in the first display area and at least partially overlapping with a portion of the touch sensor metal; and a second signal line disposed in the first display area and at least partially overlapping with another portion of the touch sensor metal.

In this case, at least one of the first signal line and the second signal line may be a data line to which an image signal is applied.

Additionally, the first signal line and the second signal line may include the same material as the relay electrode and may overlap with a bank.

A portion of the touch sensor metal and another portion of the touch sensor metal according to embodiments of the present disclosure may be connected to each other or may be spaced apart by an opening.

Additionally, the first display area may include: a first low-transmittance area in which a plurality of first emission areas are arranged; a second low-transmittance area spaced apart from the first low-transmittance area and in which a plurality of second emission areas are arranged; and an intermediate area disposed between the first low-transmittance area and the second low-transmittance area and including at least one of the plurality of transmissive areas.

Embodiments of the present disclosure may provide a display device comprising a touch sensor metal comprising: a first portion disposed in the first low-transmittance area and having a plurality of openings overlapping the plurality of first emission areas; a second portion disposed in the second low-transmittance area and having a plurality of openings overlapping the plurality of second emission areas; and a third portion disposed in the intermediate area, connecting the first portion and the second portion, and having a plurality of openings overlapping with the plurality of the transmissive areas, wherein the first portion, the second portion, and the third portion are interconnected in a mesh structure.

Embodiments of the present disclosure may provide a display device in which the touch sensor metal does not overlap with a common electrode hole. In this case, a metal patterning layer may be included in the common electrode hole.

Embodiments of the present disclosure may provide a display device in which the metal patterning layer can serve as an electron injection layer, wherein the metal patterning layer serving as the electron injection layer in the common electrode hole and the layer serving as an electron injection layer in an area where the common electrode hole is not formed can compose of different materials.

Embodiments of the present disclosure may provide a display device in which the touch sensor metal includes a first opening, a second opening, and a third opening, wherein at least one of the first opening, the second opening, and the third opening has a different size from the others.

Embodiments of the present disclosure may provide a display device comprising: a first color emission area disposed in the display area and emitting first-color light; a second color emission area disposed in the display area and emitting second-color light; and a third color emission area disposed in the display area and emitting third-color light, wherein the first opening of the touch sensor metal overlaps with the first color emission area, the second opening of the touch sensor metal overlaps with the second color emission area, and the third opening overlaps with both the third color emission area and the transmissive area.

Embodiments of the present disclosure may provide a display device in which a width of a portion of the touch sensor metal disposed at a boundary between the first opening and the third opening is different from a width of a portion disposed at a boundary between the third openings.

Embodiments of the present disclosure may provide a display device including an infrared sensor and a camera disposed below the substrate and overlapping the first display area.

Embodiments of the present disclosure may provide a display device in which the first display area includes a first optical area and a second optical area, wherein the infrared sensor overlaps with the first optical area, the camera overlaps with the second optical area, and a size of the first optical area is smaller than a size of the second optical area.

Embodiments of the present disclosure may provide a display device comprising: a substrate including a display area capable of displaying an image, wherein the display area includes a first display area having a plurality of transmissive areas and a second display area positioned outside the first display area; a first touch sensor metal disposed in the first display area and having a plurality of openings; and at least one signal line disposed in the first display area, wherein the first touch sensor metal comprises: a first portion surrounding a first emission area; a second portion surrounding a second emission area spaced apart from the first emission area in a first direction; and a third portion connecting the first portion and the second portion and disposed in a line shape, wherein the at least one signal line includes a wiring part disposed parallel to the third portion and at least partially overlapping the third portion. In this case, the at least one signal line may be a data line to which an image signal is applied.

Embodiments of the present disclosure may provide a display device comprising: a substrate including a display area in which an image is displayed and a non-display area in which an image is not displayed, the display area including a first display area having a plurality of transmissive areas and a second display area positioned outside the first display area, the non-display area including a first non-display area and a second non-display area; a touch electrode disposed in an optical area within the first display area and the second display area, and having a plurality of openings; at least one signal line disposed in the first display area; and at least one power supply line, wherein the touch electrode includes a patterned touch sensor metal in a mesh type; wherein a width of the touch sensor metal disposed in the second display area is different from a width of the touch sensor metal disposed in the optical area; and wherein the width of the touch sensor metal disposed in the second display area is smaller than the width of the touch sensor metal disposed in the optical area.

Embodiments of the present disclosure may provide a display device in which the second non-display area is surrounded by the display area, and at least a part of the second non-display area is penetrated in a thickness direction to form a sensor hole, wherein the at least one signal line and/or the at least one power supply line bypasses through, passes through or is placed in the optical area, and extends to the second non-display area by bypassing the sensor hole; and wherein the second non-display area further includes: an outer separation area between the sensor hole and the display area; a first dam area between the outer separation area and the display area; an inner separation area between the first dam area and the display area; and a second dam area between the outer separation area and the sensor hole.

Embodiments of the present disclosure may provide a display device in which in the second non-display area, at least one overhang structure is disposed in at least one of the outer separation area and the inner separation area, and an organic layer is disposed on the at least one overhang structure, wherein the at least one overhang structure is configured to be spaced apart from each other; wherein the organic layer is cut off at both ends of the overhang structure; and wherein the organic layer is a portion of a light-emitting device disposed in the display area extending into the second non-display area. In this case, the organic layer includes any one of an electron injection layer, an electron transport layer, a hole transport layer, and a hole injection layer.

Embodiments of the present disclosure may provide a display device in which the at least one overhang structure includes at least one of a planerization overhang structure and a metal overhang structure, wherein the planerization overhang structure is formed of an organic material, and the metal overhang structure is formed of a metal material. In this case, the planarization overhang structure in the second non-display area and a planarization layer in the display area are formed in a same layer and made of a same material, and the metal overhang structure in the second non-display area and a relay electrode in the display area are formed in a same layer and made of a same material.

Embodiments of the present disclosure may provide a display device in which the at least one overhang structure includes the planarization overhang structure and the metal overhang structure, wherein the planarization overhang structure is formed on the metal overhang structure, and the organic layer is formed on the planarization overhang structure, and wherein the planerization overhang structure is formed of an organic material, and the metal overhang structure is formed of a metal material.

Embodiments of the present disclosure may provide a display device further including a second touch sensor metal disposed in the second display area and having a plurality of openings, wherein the plurality of openings of the second touch sensor metal includes at least one opening having a different size from the plurality of openings of the first touch sensor metal.

Embodiments of the present disclosure may provide a display device including a transmissive area having touch performance that is the same as or substantially the same as that of a portion without a light transmission structure.

Embodiments of the present disclosure may provide a display device having a light transmission structure that allows an optical electronic device disposed below the display panel to normally receive light while maintaining touch performance in the optical area.

Embodiments of the present disclosure may provide a display device in which no brightness difference occurs between regions due to the presence or absence of the touch sensor metal, thereby improving visibility.

Embodiments of the present disclosure may provide a display device that lowers the resistance of the touch sensor metal and increases capacitance, thereby improving touch performance.

Embodiments of the present disclosure may provide a display device in which normal touch is possible even in the optical area, which is included in the display area of the display panel and overlaps with an optical electronic device.

Embodiments of the present disclosure may provide a display device in which signal lines required for display driving are arranged in the optical area where light transmission is needed while improving the transmittance of the optical area so that an optical electronic device located in the optical area can normally receive light transmitted through the optical area.

Embodiments of the present disclosure may provide a display device in which signal lines required for display driving and touch sensor metals required for touch sensing are arranged in the optical area where light transmission is needed, and by overlapping the vertical positions of the signal lines and the touch sensor metals, the transmittance of the optical area can be improved.

Embodiments of the present disclosure may provide a display device that lowers the resistance of the touch sensor metal and increases capacitance, thereby improving mobility and enabling low-power operation.

### Description of Reference Numerals

100: Display device
110: Display panel
10: Electronic device
11: First electronic device
12: Second electronic device
220: Data driving circuit
230: Gate driving circuit
240: Display controller
250: Host system
260: Touch driving circuit
270: Touch controller
800: Opening area

## Claims

1. A display device (100) comprising:
a substrate (SUB) including a display area (DA) capable of displaying an image, the display area (DA) including a first display area (DA1) having a plurality of transmissive areas (TA) and a second display area (DA2) positioned outside the first display area (DA1);
a touch sensor metal (TSM) disposed in the first display area (DA1) and positioned outside the plurality of transmissive areas (TA);
a first signal line (SL1) disposed in the first display area (DA1) and at least partially overlapping with a portion of the touch sensor metal (TSM); and
a second signal line (SL2) disposed in the first display area (DA1) and at least partially overlapping with another portion of the touch sensor metal (TSM).

2. The display device (100) of claim 1, wherein the first display area (DA1) comprises:
a first low-transmittance area (LTA1) in which a plurality of first emission areas (EAa) are arranged;
a second low-transmittance area (LTA2) spaced apart from the first low-transmittance area (LTA1) and in which a plurality of second emission areas (EAb) are arranged; and
an intermediate area (MA) disposed between the first low-transmittance area (LTA1) and the second low-transmittance area (LTA2), the intermediate area (MA) including at least one of the plurality of transmissive areas (TA).

3. The display device (100) of claim 2, wherein the touch sensor metal (TSM) comprises:
a first portion disposed in the first low-transmittance area (LTA1) and having a plurality of openings overlapping with the plurality of first emission areas (EAa);
a second portion disposed in the second low-transmittance area (LTA2) and having a plurality of openings overlapping with the plurality of second emission areas (EAb); and
a third portion disposed in the intermediate area (MA), connecting the first portion and the second portion, and having a plurality of openings overlapping with the plurality of the transmissive areas (TA),
wherein the first portion, the second portion, and the third portion are connected in a mesh structure.

4. The display device (100) of any of claims 1 to 3, further comprising:
a pixel electrode (PE) disposed on the substrate (SUB) and positioned in the first display area (DA1);
a light-emitting layer (EL) disposed on the pixel electrode (PE); and
a common electrode (CE) disposed on the light-emitting layer (EL) and having a plurality of holes dispopsed in the first display area (DA1),
wherein the touch sensor metal (TSM) is disposed on the common electrode (CE) and does not overlap with a plurality of common electrode holes of the common electrode (CE).

5. The display device (100) of claim 4, further comprising:
a transistor (TFT1) including a source electrode (S1) or a drain electrode (D1) electrically connected to the pixel electrode (PE); and
a relay electrode (RE) electrically connecting the source electrode (S1) or the drain electrode (D1) to the pixel electrode (PE),
wherein the first signal line (SL1) and the second signal line (SL2) include the same material as the relay electrode (RE).

6. The display device (100) of any of claims 1 to 5, wherein the touch sensor metal (TSM) includes a first opening, a second opening, and a third opening, and at least one of the first opening, the second opening, and the third opening has a different size from the others.

7. The display device (100) of any of claims 1 to 6, further comprising an infrared sensor and a camera disposed below the substrate (SUB) and overlapping the first display area (DA1).

8. The display device (100) of claim 7, wherein:
the first display area (DA1) comprises a first optical area (OA1) and a second optical area (OA2);
the infrared sensor overlaps with the first optical area (OA1);
the camera overlaps with the second optical area (OA2); and
a size of the first optical area (OA1) is smaller than a size of the second optical area (OA2).

9. A display device (100) comprising:
a substrate (SUB) including a display area (DA) capable of displaying an image, the display area (DA) including a first display area (DA1) having a plurality of transmissive areas (TA) and a second display area (DA2) positioned outside the first display area (DA1);
a first touch sensor metal (TSM) disposed in the first display area (DA1) and having a plurality of openings; and
at least one signal line (SL1, SL2) disposed in the first display area (DA1),
wherein the first touch sensor metal (TSM) comprises:
a first portion surrounding a first emission area (EAa);
a second portion surrounding a second emission area (EAb) spaced apart from the first emission area (EAa) in a first direction; and
a third portion connecting the first portion and the second portion and arranged in a line shape,
wherein the at least one signal line (SL1, SL2) includes a wiring part disposed parallel to the third portion and at least partially overlapping the third portion.

10. The display device (100) of claim 9, further comprising a second touch sensor metal (TSM) disposed in the second display area (DA2) and having a plurality of openings,
wherein the plurality of openings of the second touch sensor metal (TSM) includes at least one opening having a different size from the plurality of openings of the first touch sensor metal (TSM).

11. A display device (100) comprising:
a substrate (SUB) including a display area (DA) in which an image is displayed and a non-display area (NDA) in which an image is not displayed, the display area (DA) including a first display area (DA1) having a plurality of transmissive areas (TA) and a second display area (DA2) positioned outside the first display area (DA1), the non-display area (NDA) including a first non-display area (NDA1) and a second non-display area (NDA2), the second non-display area (NDA2) surrounded by the display area (DA);
a touch electrode (TE) disposed in an optical area (OA) within the first display area (DA1) and the second display area (DA2), and having a plurality of openings;
at least one signal line (SL1, SL2) disposed in the first display area (DA1); and
at least one power supply line,
wherein at least a part of the second non-display area (NDA2) includes a sensor hole (SH) in a thickness direction.

12. The display device (100) of claim 11, wherein the touch electrode (TE) includes a patterned touch sensor metal (TSM) in a mesh type.

13. The display device (100) of claim 11 or 12, wherein the second non-display area (NDA2) further includes:
an outer separation area (OSP) between the sensor hole (SH) and the display area (DA);
a first dam area (DMP1) between the outer separation area (OSP) and the display area (DA);
an inner separation area (ISP) between the first dam area (DMP1) and the display area (DA); and
a second dam area (DMP2) between the outer separation area (OSP) and the sensor hole (SH).

14. The display device (100) of claim 13, wherein in the second non-display area (NDA2), at least one overhang structure is disposed in at least one of the outer separation area (OSP) and the inner separation area (ISP), and an organic layer is disposed on the at least one overhang structure,
wherein the at least one overhang structure includes at least one of a planerization overhang structure and a metal overhang structure.

15. The display device (100) of claim 14, wherein the planarization overhang structure in the second non-display area (NDA2) and a planarization layer in the display area (DA) are formed in a same layer and made of a same material, and
the metal overhang structure in the second non-display area (NDA2) and a relay electrode (RE) in the display area (DA) are formed in a same layer and made of a same material.
